(19) Europäisches Patentamt
European Patent Office
Office européen des brevets

(11) EP 2 686 691 B1

# (12) EUROPEAN PATENT SPECIFICATION

(45) Date of publication and mention of the grant of the patent:
**01.08.2018 Bulletin 2018/31**

(21) Application number: **12723836.8**

(22) Date of filing: **26.04.2012**

(51) Int Cl.:
***G01R 31/02*** *(2006.01)* ***H02H 1/00*** *(2006.01)*
***H02H 3/42*** *(2006.01)* ***G01R 31/08*** *(2006.01)*

(86) International application number:
**PCT/EP2012/057616**

(87) International publication number:
**WO 2012/171694 (20.12.2012 Gazette 2012/51)**

## (54) A METHOD FOR DETECTING EARTH FAULTS

VERFAHREN ZUM NACHWEIS VON ERDFEHLERN

PROCÉDÉ DE DÉTECTION DE DÉFAUTS À LA TERRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.06.2011 SE 1150535**

(43) Date of publication of application:
**22.01.2014 Bulletin 2014/04**

(73) Proprietor: **Dlaboratory Sweden AB**
**223 70 Lund (SE)**

(72) Inventor: **AKKE, Magnus**
**S-224 66 Lund (SE)**

(74) Representative: **Persson, Albin**
**Hansson Thyresson AB**
**Box 73**
**201 20 Malmö (SE)**

(56) References cited:
**EP-A1- 1 598 674**
**EP-A2- 1 089 081**
**WO-A1-99/12048**
**WO-A1-2010/115474**
**WO-A2-01/84687**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

TECHNICAL FIELD

This invention relates to a method and device for detection and direction determination for a multitude of different earth fault types in a three-phase medium voltage (6 kV-50 kV) electric power distribution system.

DISTRIBUTION NETWORK AND ITS PROTECTION

Three phase distribution systems are often called medium voltage networks (MV) and typically have voltage levels from 6 kV up to 40 kV. The network carries electricity along three separate conductors while maintaining a voltage difference between any two of the conductors (line voltages). Under normal operating conditions the three voltages are symmetrical about a neutral point. Voltage measured between a conductor and the neutral point is referred to as the phase voltage.

Where star (Y) connected transformer windings are used at a source station, the star point corresponds to the neutral position. If a delta connected transformer is used at the source station, a separate transformer, often Z-connected, can be used to create the neutral point.

Each conductor or phase also has a voltage with respect to its surrounding environment, mainly the local ground or earth. Load current normally flows out in one or more of the phases and returns through the other phase wire(s).

In the event of a fault, for example a conductor coming in contact with the ground, some of the current flows into the ground. This fault current must find its way back to the source, i.e. into the electrical network. The network neutral point is generally connected to earth at the source to provide such a return path. Fault current for a network earth fault therefore generally flows from the phase conductor, through the earth and back through the neutral-earth connection.

The sum of the three phase currents, also called three times the zero sequence current, or residual current, can be measured in two or more ways. The first way is to measure each phase current by a separate current transformer and then the currents are added by wires at the secondary side of the current transformers. Another way is to use a cable current transformer, which is connected around all three phases and directly measures the residual current.

There are many ways to connect the network neutral to earth, for example, it can be solidly connected. In this case large currents can flow in the event of a network earth fault. Such faults can be detected easily but must be cleared rapidly to minimize safety hazards and equipment damage. Solid earthing is predominantly used in United States of America.

Alternatively, the neutral point can be left isolated. In this case fault current flows back into the system through a weak capacitive connection between the earth and the remaining phase wires. Relatively little fault current can flow through this capacitive link in the event of a fault and are therefore more difficult to detect. Isolated neutral earthing is predominantly used in networks without any cables, typically rural networks with overhead lines only.

In another form of neutral earthing, an impedance is used in the neutral point which limits the fault current and reduce the risk for damage. This arrangement is referred to as a high impedance earthed network. Isolated neutral networks fall into the category of high impedance earthed networks.

High impedance earthed networks offer better operational performance. If the fault current at the fault location is reduced to a very low level it is possible to maintain supply in the event of an earth fault. One common method to reduce the fault current at the fault site is to install an arc-suppression coil in the neutral-earth link at the source station. The coil diverts or tunes out most of the capacitive fault current.

High resistive faults are typically associated with fallen conductors or accidental contact with a live conductor and are extremely dangerous to humans and animals. It is desirable to be able to detect such high resistive faults, which is referred to as the sensitivity of the earth fault protection system.

There are also factors working against sensitive protection. During the normal operation of a network there is always a certain amount of current flowing to earth through the inherent capacitive links between each phase conductor and earth. However, Petersen coil earthing has an overall positive impact on supply continuity and supply quality for overhead networks.

Wattmetric protection measures residual current on a feeder and forms a product with the neutral point voltage. The product is proportional to active power, hence the name Wattmetric protection. The product gives a directional indication of the source of the fault and can be used to identify faulty feeders. Often neutral point voltage (or displacement) is used as back-up protection for earth faults in the network. If the Wattmetric fails to operate, then the backup protection based on neutral point voltage will disconnect all feeders in the transformer station.

Petersen coil earthing imposes higher voltage stress on a network and might lead to double earth faults. The first earth fault cause a voltage increase on the healthy phases, which might cause a second earth fault on a second phase. This is also called a cross-country fault and can have much more serious consequences than a single earth fault.

Arc-suppression with a Petersen coil is frequently used in MV networks. Figure 1 illustrates a Petersen earthed distribution network with three feeders, one faulted and two healthy feeders. Figure 2 illustrates a simplified equivalent circuit, which can be used to describe the behavior of the neutral point voltage, and the relation between the feeders' residual currents and neutral point current.

However, there are significant difficulties with arc-suppression; the main difficulty being to correctly "handle" all types of earths faults. More specifically, "handle" includes both conventional relay protection, but also means to report correct information about all earth fault abnormalities. So the definition of "handle all types of earths faults" is much broader and in essence means to report correct information about the origin of all earth faults that cause abnormalities in either neutral point voltage, or any feeder residual current.

## PRIOR ART

A conventional earth-fault protection is described in DEA4413068. Conventional earth-fault protection and fault detectors are designed for permanent earth faults. Conventional detection methods are mainly based on phasor and Fourier results. Therefore, these methods are actually targeting at steady sinusoid signals. However said results may be inaccurate, even incorrect if the event lasts for less than half a cycle. Conventional phasor based methods are less suitable in dealing with transient and non-steady sinusoid signals. The conventional earth-fault relaying and fault detectors operate randomly in connection with other fault types, giving unreliable information.

EP0999633 describes a phasor method that stores pre-fault signals and post-fault signals to distinguish the faulted feeder. The method of subtracting pre-fault signals from post-fault signals is often called "delta quantities" by relaying engineers. The major drawback is that the method needs to define some criteria to separate between pre- and post-fault condition. The method works for transition from a well-defined healthy network, which goes into a faulted network. However the said method becomes unreliable and less useful for evolving faults, where the network goes through a sequence of different faulted conditions. Another drawback is that the method utilizes information from the fundamental frequency only.

There are methods specifically designed for restriking (intermittent) earth faults which have constantly recurring voltage and current transients such as disclosed in WO1999012048. The basic idea of WO1999012048 is to compare the polarities of the current peaks with each other, or with the sign of the instantaneous value of faulted phase voltage. A drawback of the method is that only single samples are used for decision making, which makes it unreliable. The method works for a limited set of faults that are some kilometers out from the feeders, which does not contain any high frequency transients. As illustrated by the fault recording in Fig 7B, it becomes nearly impossible to use individual samples for decision making if the earth fault contains higher frequencies. Fig 7B is representative for re-striking faults that occur closer to the feeding transformer, hence it is doubtful if the method in WO1999012048 will provide reliable results for close-in earth faults. Also, the concept of calculating current peaks seems unreliable for high frequency current signals that might be the sum of wave propagation and various reflections in the network.

Similar methods are disclosed in EP 1 089 081 A2, EP 1 598 674 A1 and WO 01/84687 A2.

For Petersen earthed networks, a system disclosed in WO2010115474 uses active power to determine the faulted feeder. The innovation is that the calculation of power is based on true RMS, rather than the conventional phasor based calculation, which calculates active power for the fundamental frequency only.

Conventional phasor based method is less useful for transient signals. However, they can still be useful in some situation if no distinct transient can be identified. Conventional wattmetric relay (active power) has problems to work correctly under transient/intermittent situations. A method is needed which solves this.

## SUMMARY OF THE INVENTION

The present invention is directed to a method for detecting earth faults according to claim 1. Advantageous embodiments of the invention are described in the dependent claims.

Therefore, the method in accordance with the present invention is focused on detection of a large catalogue of various earth faults. A direction method is presented which use the transient information to discriminate the faulty feeder(s) from healthy feeders.

The method presented below offers a solution, by combining a transient method with a modified phasor based wattmetric method (active power). The invention concerns a method and a device for reliable detecting and monitoring a multitude of different earth faults in three-phase electric power distribution networks. Abundant transient information is used for fault detection. Using prior art Fourier transform actually filters out these high frequency components. A method is presented which combines a transient estimation method with a modified phasor based wattmetric method. The transient method estimates the capacitance and conductance of each feeder, and also the neutral point device, and uses this to find the faulted feeder. The modification of the wattmetric method involves using the negative derivative of the neutral point voltage magnitude to identify when the fault is not connected and then to disable (block) the active power criterion.

BRIEF DESCRIPTION OF THE DRAWINGS

In order that the manner in which the above recited and other advantages and objects of the invention are obtained will be readily understood, a more particular description of the invention briefly described above will be rendered by reference to specific embodiments thereof which are illustrated in the appended drawings.

Understanding that these drawings depict only typical embodiments of the invention and are not therefore to be considered to be limiting of its scope, the invention will be described and explained with additional specificity and detail through the use of the accompanying drawings in which:

Fig 1 schematically illustrates a conventional power distribution system.
Fig 2 schematically illustrates the relation between the neutral point current and the residual current in the feeders.
Fig 3A shows a graph of a neutral voltage and residual currents during a time frame of 500 ms where a single transient earth fault occurs.
Fig 3B is a close up of Fig 3A.
Fig 4A shows a graph of a neutral voltage and residual currents during a time frame of 1 second where temporary earth fault with fundamental frequency occurs.
Fig 4B is a close up of Fig 4A.
Fig 5A shows a graph of a neutral voltage and residual currents during a time frame of 10 second where an intermittent earth faults with 5 strikes occurs.
Fig 5B is a close up of Fig 5A.
Fig 6A shows a graph of a neutral voltage and residual currents during a time frame of 1 second where an intermittent earth faults with 6 strikes occurs.
Fig 6B is a close up of Fig 6A.
Fig 7A shows a graph of a neutral voltage and residual currents during a time frame of 500 ms where an intermittent earth faults with 9 strikes occurs.
Fig 7B is a close up of Fig 7A.
Fig 8A shows a graph of a phase voltages, neutral voltage and residual currents during a time frame of 800 ms where an evolving fault occurs.
Fig 8B is a close up of Fig 8A.
Fig 9 shows a flow chart for a combined method according to the present invention.
Fig 10 illustrates an implementation of the transient method according to the present invention.
Fig 11 shows a flow chart for the modified wattmetric method according to the present invention.
Fig 12A shows a graph of three phase voltage, neutral voltage and residual currents during a time frame of 400 ms where a single transient earth fault occurs.
Fig 12B shows a close in graph of the residual currents during a time frame of 30 ms where a single transient earth fault occurs.
Fig 12C shows a close in graph of the estimated conductance G and capacitance C, during a time frame of 30 ms where a single transient earth fault occurs.
Fig 13A shows a graph of, neutral voltage and residual currents during a time frame of 800 ms where an intermittent earth fault occurs.
Fig 13B shows a close in graph of the residual currents during a time frame of 80 ms where an intermittent earth fault occurs.
Fig 13C shows a close in graph of the estimated conductance G and capacitance C, during a time frame of 80 ms where an intermittent earth fault occurs.
Fig 13D shows a close in graph of the phasor calculations of neutral voltage magnitude, its derivative and active power, during a time frame of 80 ms where an intermittent earth fault occurs.
Fig 14 schematically illustrates a substation with common protection, that is, each feeder has its own protective device in accordance with the invention.
Fig 15 schematically illustrates a substation with one integrated protection system for the entire substation, that is, all feeders are protected by one device in accordance with the invention only.

DETAILED DESCRIPTION

DIFFERENT TYPES OF EARTH FAULTS

Several different types of earth faults occur in the electricity distribution network. These faults have very different characteristics, and the main challenge for an earth fault protection system is to be secure, dependable and sensitive for *all* types of earth faults.

Therefore this subsection exemplifies some different types of earth faults which have been recorded by a high performance fault recorder at a (130kV / 20kV) transformer station in southern Sweden. The fault recorder was based on LABVIEW software and cRIO hardware (NATIONAL INSTRUMENT, Austin, Texas, United States of America) with 50 kHz simultaneously sampling, 22 kHz effective bandwidth, 24-bit resolution, and up to 10 second recording length. Figures are used to illustrate the different faults types.

PERMANENT EARTH FAULTS

Some of the faults establish a relatively stable connection between a phase conductor and earth. In cable networks permanent faults require disconnection of the faulty cable section from the network.

On overhead lines, electric arcing faults are more frequent. For example, bird feces might pollute an open air insulator and ignite an arc. One advantage with the Petersen coil is that it helps to reduce the fault current, so these faults often disappear by themselves, often called "self-healing earth fault". In this case no relay operation is required. Therefore the trip signal from the relay protection is often delayed for some seconds, to give the fault a chance to self-heal. If the faults duration is longer, an arcing fault can be eliminated by disconnecting, i.e., de-energizing the line for some seconds.

Regardless of whether the permanent faults have an electric arc, or not, they can be easily identified and eliminated by using the generally known technique of protective relays.

TRANSIENT EARTH FAULTS

Figure 1 shows a basic configuration using a Petersen coil 10 connected to the neutral point of a three-phase power transformer 12. Each phase of the power transformer 12 is connected to a busbar 14 from which a plurality of feeders 16A, 16B to 16N are available through a plurality of breakers 18. Further description of said breakers follows below with reference to Figure 14 and Figure 15.

Figures 3A and 3B illustrate an earth fault with a single transient. It is believed that this type of fault might result from insulation breakdown caused by moisture, giving an arc that evaporates the moisture and then self-heal the insulation and rapidly switch-off the fault.

The lower graph in Figure 3A shows a high amplitude transient with short time duration. The amplitude of the sum of phase current, also called residual current, is nearly 1000 A. The upper graph in Figure 3A shows the neutral point voltage which oscillates due to resonance tuning between the inductance of the Petersen coil and the feeders capacitance to earth. The phenomena can be view as the residual current acting as an impulse, which excite the resonance circuit consisting of the Petersen coil in parallel with the feeder capacitance, as depicted in Figure 2. Figure 3B shows a close up of Figure 3A and shows the transient when the fault is connected. It is important to understand, that the fault is only connected for very short time duration. When the fault is present the resonance circuit is disturbed from its equilibrium. After the fault is disconnected the network is healthy, but since the resonance circuit is not at equilibrium, it will continue to oscillate with decaying amplitude until it settles. Hence, magnitude of neutral point voltage alone, is insufficient as criteria to for a connected earth fault. Information about the derivate of the magnitude of the neutral point voltage is also needed.

For a single transient like Figure 3A it is not necessary to trip the breaker and disconnect the feeder. However, the information about the transient is useful and should be used. The disturbance should be reported and the faulted feeder should be identified. The information is useful for preventive maintenance and also as an early warning system. In conclusion, it is essential that our earth fault method can also handle this type of earth faults.

TEMPORARY EARTH FAULTS OF FUNDAMENTAL FREQUENCY

Figure 4A and 4B illustrate temporary earth faults that self-heals and disappears after around 50 ms. In contrast to transient earth faults, both current and voltage magnitude are small, and the quantities are mainly of fundamental frequency. Hence there is little transient information with short time duration (less than 20 ms), available to analyze this fault type. Therefore this fault type needs to be analyzed by fundamental frequency methods, such as DFT-phasors.

INTERMITTENT (RE-STRIKING) EARTH FAULTS

This type of earth fault is called an intermittent, or re-striking, earth fault. The earth contact alternately occurs and disappears causing a long-lasting disturbance in the network if the faulty line section is not disconnected from the network.

Re-striking earth faults are common in Petersen earthed networks and usually occur in connection with damaged insulation. Intermittent faults occur in places where insulation of cables, cable terminal boxes, or cable joints are damaged due to mechanical stress, material failure or ageing. A restriking earth fault may also emerge in a new underground cable as a result of mechanical stress caused during earth excavation.

Three different types of intermittent earth faults are presented, which clearly illustrates that intermittent faults might have very different characteristics.

Figures 5A and close up in 5B show the first example of an intermittent earth fault with five strikes within 10 seconds recording time. The characteristic feature of the disturbance is that the duration between each strike is so long that all quantities settle to zero before the next strike. Hence there is no overlap between the strikes and each strike occurs from steady state condition where all quantities are close to zero. For this type of intermittent fault the neutral point voltage goes to zero, which will reset the timers for the neutral point voltage relay, hence eliminating the risk for unwanted trip.

Figures 6A and close up in 6B show the second example of an intermittent earth fault with five strikes within less than one second recording time. The characteristic feature of the disturbance is that the duration between each strike is so short that the voltage transient has only decayed to around half, before the next strike occurs. Hence the transient from the strikes overlap. For this type of intermittent fault the neutral point voltage remains high as long as the intermittent fault is present. If the duration of the intermittent fault exceeds the time delay of the neutral point protection, there is an obvious risk for unwanted trip. This is bad since this protection is as back-up protection and disconnects all feeders in the entire substation.

Figures 7A and close up in 7B show the third example of an intermittent earth fault with a multitude of high frequency current peaks within less than one second recording time. The characteristic feature of the disturbance is the high frequency content in the residual current. The reason is that the fault location is very close to the point where the disturbance has been recorded. As seen from the zoom in Figure 7B, the feeders' currents have several peaks with opposing sign even within a time frame of less than 1 millisecond.

CROSS COUNTRY EARTH FAULTS

In a Petersen earthed network, the first earth fault cause a voltage increase on the healthy phases. This is illustrated in Figure 8A, during time period from 200 ms to 400 ms. The voltage increase on the healthy phases cause more stress on the other part of the network. If some part of the non-faulty network contains a component with beginning insulation breakdown, there is now an increased risk that a second earth fault will be initiated. This is shown in the lower graph in Figure 8B, where the current measurements range saturates at 600 A and 1000 A. Two earth faults in different phases will nearly behave as a short-circuit giving very large residual current. The fault type is called a "cross-country" fault and can have much more serious consequences than a single earth fault.

EVOLVING EARTH FAULTS

Some earth fault methods are based on the assumption that the network goes from a well-defined healthy state to a faulted state. However, in many situations the faults appears in a sequence of several events, which is shown in Figure 8A.

Figure 8A shows the following sequence of events:

1) The first fault event is a single earth fault at 295 ms;
2) The second event occurs at 464 ms and is the second earth fault but in a different phase, resulting in a cross country fault.
3) The third event occurs at 550 ms and is third fault on the last healthy phase, resulting in low neutral point voltage, but still high currents.
4) The fourth event occurs at 670 ms, when one feeder is tripped for overcurrent, disconnecting two faulted phases, leaving the network with one single earth fault.
5) The fifth event occurs at 680 ms, when the remaining earth fault self-extinguish.

As shown in Figure 9, the invention is a method that aims to detect and determine the direction of all types of earth faults. The invention combines two new methods, namely, one transient method which estimates conductance and capacitance, and one fundamental frequency method, called "Wattmetric with blocking". By doing so it is possible to handle a multitude of different fault types.

The phrase "residual current" is equivalent to "sum of phase current", or $3*I_0$. The motivation to use a combined method can be explained by Figure 2. It shows that the residual current entering the faulted feeder is the neutral point current and the sum of the residual current from all the healthy feeders, but with reversed sign, that is, it is negative. The inductance of the coil in neutral point, gives that the neutral point current has much slower dynamics than the feeder currents. This is also illustrated by recording, for example Figure 3B. Figure 2 can be used to model the electrical properties of each feeder. These properties are modelled by two parameters, namely the conductance, notation $G=1/R$, and the capacitance, notation C. For the healthy feeders the estimation will result in G and C for respective feeder. For the faulted feeder, the current has negative sign. For fast transients, the current entering the faulted feeder is approximately the sum of the residual currents from the healthy feeders, but with reversed sign. Hence, for fast transients the estimation for the faulted feeder will give the sum of G and C for the healthy feeders, but with reversed sign, that is negative values.

However, for slower dynamics, typically in the range of fundamental frequency, the coil current grows in magnitude and can no longer be neglected. At 50 Hz, the coil should be tuned so its current should compensate the capacitive feeder currents. Hence the inductive coil current is in the same range as the sum of the capacitive currents. If the coil current is slightly too large (over-compensated), the 50 Hz current entering the faulted feeder is inductive. If the coil current is slightly too small (under-compensated), the 50 Hz current entering the faulted feeder is capacitive. At 50 Hz, an inductive current looks the same as a negative capacitive current. Therefore it is impossible to find the faulted feeder by using relation between reactive and capacitive currents at 50 Hz. This is the reason that Watt metric methods (active power) has to be used at 50 Hz.

The basic idea with the transient method is to estimate the two parameters G and C at transient state. This idea works during transient state, but fails when the signal is dominated by fundamental frequency. The key is to use the neutral point current as criterion when the method provides reliable estimates. So in addition to estimating G and C for the feeders, the two parameters are also estimated for the neutral point current. By doing so, it is possible to separate the time window where transients dominates from to time span when the signal is dominated by 50 Hz

Next the transient method is described, which is believed to be a new concept and therefore this part is extensive with more details. Then the method for fundamental frequency is described, which is more of a modification of a well know idea to use active power. Here the new idea is to use the derivate of the magnitude of the DFT-phasor of neutral point voltage to identify when the fault is connected or not. This section is slightly shorter.

The proposed method has been evaluated with fault recordings from a transformer station in southern Sweden. A high performance fault recorder has been active for 9 months and recorded more than 500 disturbances of which around 70 have been of larger amplitude. The last section shows two examples of test results using these recordings. One example is a single transient for which the transient method works perfectly. The second example is a disturbance with an intermittent fault, where there are several transients during a part of a second. The second example is used to illustrate when the fundamental frequency method can be useful as an alternative when the transient method has insufficient information due to a large 50 Hz component.

DESCRIPTION OF TRANSIENT METHOD

The term "residual current" is synonymous to "sum of phase currents", and "three times the zero sequence current (3*IO)". The residual current entering each feeder, *i*, can be modeled as,

$$i = Gu + C\frac{du}{dt} \qquad (1)$$

where *u* is the neutral point voltage, and G and C are the feeder conductance and capacitance, respectively. Note that the equation is a duality to the differential equation used for distance relaying, that is,

$$u = Ri + L\frac{di}{dt}.$$

Introduce the notation

$$w = \frac{du}{dt}. \qquad (2a)$$

For a discrete system with sampling interval, h, there are a multitude of methods to approximately calculate the voltage derivative. One simple method is to use the discrete time approximation

$$w_k \approx \frac{1}{h}(u_k - u_{k-1}) = \left(\frac{1-q^{-1}}{h}\right)u_k \qquad (2b)$$

For a finite set of n samples, the relation can be written

$$I = U\theta \qquad (3)$$

with

$$I = \begin{pmatrix} i_1 \\ i_2 \\ \vdots \\ i_n \end{pmatrix} \qquad U = \begin{pmatrix} u_1 & w_1 \\ u_2 & w_2 \\ \vdots & \vdots \\ u_n & w_n \end{pmatrix} \qquad \theta = \begin{pmatrix} G \\ C \end{pmatrix} \qquad (4)$$

The parameters can be solved from

$$\begin{pmatrix} G \\ C \end{pmatrix} = (U^T U)^{-1} U^T I \qquad (5)$$

Calculation gives

$$(U^T U)^{-1} = \frac{1}{\det(U^T U)} adj(U^T U) \qquad (6)$$

with

$$\det(U^T U) = \left(\sum_{k=1}^{n} u_k^2\right) \cdot \left(\sum_{k=1}^{n} w_k^2\right) - \left(\sum_{k=1}^{n} u_k w_k\right)^2 \qquad (7)$$

and

$$adj(U^T U) = \begin{pmatrix} \sum_{k=1}^{n} w_k^2 & \sum_{k=1}^{n} u_k w_k \\ \sum_{k=1}^{n} u_k w_k & \sum_{k=1}^{n} u_k^2 \end{pmatrix} \qquad (8)$$

From these relations G and C can be estimated as:

$$\hat{G} = \frac{1}{\det(U^T U)}\left[\left(\sum_{k=1}^{n} w_k^2\right)\left(\sum_{k=1}^{n} u_k i_k\right) - \left(\sum_{k=1}^{n} u_k w_k\right)\left(\sum_{k=1}^{n} w_k i_k\right)\right] \qquad (9a)$$

$$\hat{C} = \frac{1}{\det(U^T U)}\left[\left(\sum_{k=1}^{n} u_k^2\right)\left(\sum_{k=1}^{n} w_k i_k\right) - \left(\sum_{k=1}^{n} u_k w_k\right)\left(\sum_{k=1}^{n} u_k i_k\right)\right] \quad (9b)$$

COMPACT NOTATIONS

Use an estimation window with n samples. Introduce the notations for variance of voltage and its derivative

$$\left(\sum_{k=1}^{n} u_k^2\right) = \mathrm{var}(u) = A \qquad \left(\sum_{k=1}^{n} w_k^2\right) = \mathrm{var}(w) = B \quad (10)$$

Use the following notations for covariance between voltage and its derivative

$$\left(\sum_{k=1}^{n} u_k w_k\right) = \mathrm{cov}(u,w) = D \quad (11)$$

Use notation *H* for the determinant, then

$$H = AB - D^2 \quad (12)$$

Introduce the following notations for covariance between the residual current for feeder *m* and, voltage and its derivative, respectively.

$$\left(\sum_{k=1}^{n} u_k i_{m,k}\right) = \mathrm{cov}(u, i_m) = E_m \quad (13a)$$

$$\left(\sum_{k=1}^{n} w_k i_{m,k}\right) = \mathrm{cov}(w, i_m) = F_m \quad (13b)$$

Using these notations, the parameter estimation for feeder m becomes

$$\hat{G}_m = \frac{BE_m - DF_m}{H} \quad (14a)$$

$$\hat{C}_m = \frac{AF_m - DE_m}{H} \quad (14b)$$

Note that the approximation cov($u$,$w$)≈0 is in general not valid and cannot be used to simplify the equations.

RECURSIVE EQUATIONS

The estimation can be re-formulated as recursive equations, which is simpler to implement on real time system with bounded capacity,

$$A_k = (1-\varepsilon)\cdot A_{k-1} + \varepsilon \cdot u_k^2 \quad (15a)$$

$$B_k = (1-\varepsilon)\cdot B_{k-1} + \varepsilon \cdot w_k^2 \qquad (15b)$$

$$D_k = (1-\varepsilon)\cdot D_{k-1} + \varepsilon \cdot w_k \cdot u_k \qquad (15c)$$

$$E_k = (1-\varepsilon)\cdot E_{k-1} + \varepsilon \cdot u_k \cdot i_k \qquad (15d)$$

$$F_k = (1-\varepsilon)\cdot F_{k-1} + \varepsilon \cdot w_k \cdot i_k \qquad (15e)$$

where $0<\varepsilon<1$.

Note that E and F has to be calculated for each feeder current, but *A, B*, *D* depend only on neutral point voltage which is common for all feeders.

GENERAL LOW PASS FILTERING

It is observed that the recursive formulation can be interpreted as a first order IIR-filter of inputs where the inputs are:

$$\mathrm{Input}_{\mathrm{A}} = u_k^2 \qquad \mathrm{Input}_{\mathrm{B}} = w_k^2 \qquad \mathrm{Input}_{\mathrm{D}} = w_k u_k$$

$$\mathrm{Input}_{\mathrm{E}} = u_k i_k \qquad \mathrm{Input}_{\mathrm{F}} = w_k i_k$$

From this perspective, it is possible to employ any kind of low-pass filter for the estimation. Figure 4.1 - 4.3, below illustrate an implementation in the simulation software Simulink using the general low pass filter approach.

DETERMINANT SCALING

However, one classic problem with above formulation is the division with the determinant *H*. If the determinant becomes very small and goes towards zero, the estimation accuracy is poor. It is important to note that the determinant *H* only depends on voltage *u* and its derivative which is common for all feeders. Hence the determinant is identical for all feeders and can be viewed as a common scaling factor, which is always positive, or zero. It follows from

$$H = \left(\sum_{k=1}^{n} u_k^2\right)\left(\sum_{k=1}^{n} w_k^2\right) - \left(\sum_{k=1}^{n} u_k w_k\right)^2$$

which is always positive, or zero, since

$$\left(\sum_{k=1}^{n} u_k^2\right)\left(\sum_{k=1}^{n} w_k^2\right) \geq \left(\sum_{k=1}^{n} u_k w_k\right)^2 .$$

Hence the determinant does not influence the sign of estimated parameters $\hat{G}_m$ and $\hat{C}_m$.

The determinant *H* tends to zero, as the neutral point voltage decrease to zero. The determinant can also go to zero if the matrix is singular, which, means that rows, and columns are linear combination of each other. In system identification, a singular matrix tells that all parameters cannot be uniquely identified from the given data. In a sense, the determinant reflects the quality, or richness, of the data. To avoid numerical problems, the determinant is bounded to some very small value. To find the faulted feeder, it is sufficient to know the sign of the estimated parameters G and C. The coil current is included as an extra feeder in the estimation. The estimated parameter for the coil current is used to enable the estimation of faulted feeder. The criteria for fault indication based on estimated capacitance becomes

$$\text{if } C_{\text{Feeder no X}} < C_{\text{Coil}} \Rightarrow \text{Feeder no X is faulted} \quad \text{(A)}$$

The criteria for fault indication based on estimated conductance is

$$\text{if } G_{\text{Feeder no X}} < G_{\text{Coil}} \text{ and all other feeders} \Rightarrow \text{Feeder no X is faulted} \quad \text{(B)}$$

The criterions (A) and (B) can be combined to form logical conditions that set a memory circuit with the faulted feeder.

USE NEUTRAL POINT VOLTAGE TO ESTIMATE COIL CURRENT

One drawback with the transient method is that the coil current is needed to find the faulted feeder. For conventional directional earth fault protection, only the neutral point voltage and the residual current are used to find the faulted feeder. In some network stations, the coil current is not measured, and it will be an additional expense to measure it. If so, one solution is to use the neutral point voltage to estimate the coil current. The notations in Figure 2 are used. Assume that the dynamic of the coil current can be modeled by a *series* connection of a resistance and inductance. Using differential equations, the relation between the neutral point voltage and coil current can be written as:

$$u_0 = R \cdot i_N + L \cdot \frac{di_N}{dt} \quad \text{(16a)}$$

Using Laplace transforms, notation s, and rewriting, gives that $i_N$ can be calculated by low-pass filtering of $u_0$, as

$$i_N = H(s) \cdot u_0\,, \quad \text{(16b)}$$

where *H(s)* is the transfer function for a low-pass filter

$$H(s) = \frac{\frac{1}{R}}{(1 + \frac{L}{R} s)} \quad \text{(16c)}$$

The parameters L and R can be determined from known, or approximated coil data.

IMPLEMENTATION

The algorithm has been implemented in MATLAB/SIMULINK and been tested with fault recordings from southern Sweden, recorded from 7 August, 2010 to 1 April 2011. Figure 10 shows the three implementation steps.

In the implementation, the quantities A to F are calculated using a general low-pass filter

$$H_{LP} = \frac{B(q)}{A(q)}$$

where *B*(*q*) and *A(q)* are polynomial in the shift operator. The filters can be typically be design with Matlab and its signal processing toolbox. The specific choice of

$$B(q) = (1 + q^{-1} + q^{-2} + \ldots + q^{-n+1})$$

$$A(q) = 1$$

corresponds to the derivation in equation (2)-(9)

DESCRIPTION OF FUNDAMENTAL FREQUENCY METHOD

Figure 11 is a flowchart for the fundamental frequency method. For some earth fault such as intermittent, the network goes through a sequence of switching were the fault is connected for a short time period and then disconnected.

The underlying problem the method address, is that Wattmetric methods (active power) only give correct directional information when the fault is connected. For a network without any faults connected the flow of active power cannot be used to identify the faulted feeder.

During a sequence of intermittent faults, the fault is connected for short time duration, typically a fraction of a cycle, and then the fault is disconnected for a significantly longer time periods, and then the sequence is repeated. The neutral point voltage dynamic is governed by a resonant circuit, as shown in Figure 2, which if disturbed from its equilibrium point, will show a poorly damped oscillation. So even if the fault is only connected for a short time duration, say 5-10 ms, the neutral point voltage can oscillate for more than 100 ms. The result given by any Wattmetric method, or any method based on active power, is only reliable when the fault is connected. Once the fault is disconnected, the voltage source in the equivalent circuit in Figure 2 is disconnected, and there is a free oscillation between the Petersen coil and the all healthy feeders in the network.

The basic idea is to use a conventional phasor calculation of the fundamental frequency components. The magnitude of the neutral point phasor is used to determine if the fault is connected or not. Decaying amplitude of said phasor is used to characterize that the fault is disconnected. The decaying amplitude is identified by checking if the derivative of the voltage magnitude is negative. If the fault is disconnected, then Wattmetric methods give unreliable results, hence appropriate action should be taken in the relaying device, such as disable (block) algorithms, which use Wattmetric information. For example, a blocking signal should be sent to timers and counters that are used for tripping.

With this modification it is possible to determine when Wattmetric methods give reliable results. The modification can be used to modify existing Wattmetric relays that protections a single feeder, for example block the trip counter when the method classifies the fault as being disconnected. The method could also be used to make one coordinated relay for all feeders in the substation. Consider a common relaying platform, which measures all residual currents in the substation. When the method classifies the fault as being present, then the feeder with most negative active power is the faulted feeder, which sets a memory element. The memory element, keeps the information about the faulted feeder from the latest fault. The principle is illustrated in Figure 13D.

Note that power direction depends on the definition of positive power direction; for some power utilities positive direction is towards the busbar, for others it is reversed. The important fact is that all healthy feeders will have the same power direction and that the faulted feeder's power direction will be opposite.

This section presents two application examples, which illustrate the use of the method. The first example is a single transient fault, for which the transient method works perfectly well. The second example is chosen to illustrate that sometimes the transient method does not get sufficient information and has to be supplemented with the modified Wattmetric method.

EXAMPLE 1 - SINGLE TRANSIENT EARTH FAULT

This example illustrates how the transient method that estimates conductance G and capacitance C, works. The disturbance has been recorded in a substation in southern Sweden and the sampling rate was 50 kHz. Figure 12A shows an overview and the three graphs are (from top to bottom): phase voltages, neutral point voltage, and residual currents, respectively. In the lower graphs, the faulted feeder is shown, together with two of the healthy feeders and the neutral point current.

The neutral point voltage shows one initial transient and then decays, the feeder currents displays a large initial transient and then goes to low amplitudes. This indicates that earth fault has only been shortly connected, for some milliseconds.

Figure 12B is a close of neutral point and feeder currents. Figure 12B shows the initial current transients and clearly demonstrates that during the first 1-2 milliseconds, the feeder current are much larger than the coil current (notation Npkt in Figure 12B). Figure 12B also illustrates that the coil current has much slower dynamic response than the feeder current.

The neutral point voltage, together with feeder currents and coil currents, have been used as input to the transient method to estimate conductance G and capacitance C. Figure 12C shows the resulting estimation of G and C. The upper graph shows the estimated conductance G, and during the first 1-2 ms, the faulted feeder has largest magnitude and has negative sign. The negative sign can be explain by Fig 2, which tells that the current in the faulted feeder has reversed sign compared to the healthy feeders. The lower graph in Figure 12C shows the estimated capacitance C. During the time period 341 -350 ms, the estimated capacitances for the healthy feeders are positive and correspond well with the expected capacitance values for these feeders.

Use the lower graph in Figure 12C to compare C for the coil with the faulted feeder. During the first milliseconds the estimated C for the coil current slowly increases, and is very small compared to the estimated C for the healthy feeders. This explains why the faulted feeder gets a large negative estimate of C. The slow dynamics in coil current is reflected in the slow dynamics of the estimated C for the coil.

The idea is use the coil's C to find reliable transient information. The rule is simple; a feeder is identified as faulted, if its estimated capacitance is more negative than the estimated C for the coil. An additional criteria is that the capacitance should be less than a minimum threshold, this is to handle the situation when all capacitances are very close to zero.

EXAMPLE 2 - INTERMITTENT EARTH FAULT

This example illustrates a situation where the modified phasor method is more reliable than the transient method. The disturbance has been recorded in a substation in southern Sweden and the sampling rate was 50 kHz. Figure 13A shows an overview and the two graphs are (from top to bottom), neutral point voltage, and residual currents. In the lower graph, the current in the faulted feeder is shown, together with two of the healthy feeders and the neutral point current.

The distinct feature of this disturbance is that there are five strikes during less than a second. The neutral point voltage rises rapidly and then decays, but before it has settled down to zero, there is a new strike that increases the neutral point voltage. It can also be seen that the neutral point current has a significant 50 Hz component, which does not settle between the strikes.

In this situation, it might be that the decision criterion for the transient method is not fulfilled during the later strikes hence it gives no information from the second strike and the following strikes. Note that this is not the same as the transient method is giving erroneous information; it simply says that the transient information is insufficient to make a secure decision. The reason that the transient method will not give results for other than the first strike, is that the transients in feeder currents are insufficient to exceed the large 50 Hz component in neutral point current which was created from previous strikes.

Figure 13B shows a close up of the second strike; between 540 ms to 620 ms. It clearly shows that the 50 Hz component of the coil current is always of larger amplitude than the transients in feeder currents. This is also reflected in the estimation of the transient parameters G and C. Figure 13C shows that the neutral point current gets largest estimation magnitude both for G and C. Hence, during this time period it is uncertain if the estimated C for the faulted feeder will be more negative than the estimated C for the neutral point current.

So in this situation, there is distinct 50 Hz component present and less transient information. Then the modified Wattmetric method is useful as a fallback method. The upper graph in Figure 13D shows the magnitude of the neutral point voltage phasor, which has been calculated by a conventional DFT-method. The middle graph in Figure 13D shows the derivate of the neutral point voltage magnitude. In the graph there is also an example threshold, to identify a negative voltage derivate.

The threshold should be slightly less than zero, so that stationary faults are not blocked. But the threshold should block when the magnitude of neutral point voltage decays with a slow time constant.

The lower graph in Figure 13D shows the active power (Wattmetric) for the healthy and faulted feeders. It clearly demonstrates that as long as the voltage magnitude derivative is above the threshold, the active power for the faulted feeder is negative and largest in magnitude. So to combine active power with derivate of voltage phasor magnitude is a safe and dependable way of identifying the faulted feeder.

The electric power distribution system shown in Figure 14 comprises a plurality of protection devices 20 in accordance with the invention. Each feeder 16A - 16N is provided with a separate protection device 20. In various embodiments all method steps as set out above are performed in each protection device 20. If a feeder 16A - 16N is considered faulty by the protection device 20 different actions can be taken. In various embodiments the protection device 20 in case of a discovered fault transmits a report to a supervising system. The report includes information about the faulty feeder and further actions then can be taken by the supervising system. As shown in Figure 14 the protection device 20 transmits a trip signal as depicted by arrow 22 to a breaker 18 and the faulty feeder will be disconnected.

Each protection device 20 is connected to current measuring devices sensing the current $I_0$ in all phases of a single feeder 16A - 16N. The voltage $U_0$ appearing at the neutral point of the power transformer is measured and a signal representative of the voltage $U_0$ also is fed to the protection device 20.

In an alternative embodiment as shown in Figure 15 an electric power distribution system is provided with an integrated central protection device 24. The integrated central protection device 24 receives signals representative of the currents $I_0$ in all phases of all feeders 16A - 16N. The voltage $U_0$ appearing at the neutral point of the power transformer is measured and a signal representative of the voltage $U_0$ also is fed to the integrated central protection device 24. An alarm or report signal is generated in the integrated central protection device 24 in case of a detected faulty feeder. A trip signal 22 also can be forwarded to the breaker 18 associated to the faulty feeder.

Information relating to measured signals, estimated values and the outcome of all steps taken is gathered in a log file. The log file is continuously recorded and can be used to analyse power system events that have occurred.

While certain illustrative embodiments of the invention have been described in particularity, it will be understood that various other modifications will be readily apparent to those skilled in the art without departing from the scope of the invention as defined by the appended claims.

**Claims**

1. A method for detecting earth faults in three-phase electric power distribution networks comprising a coil (10) connected to a neutral point of a power transformer (12), including continuously measuring at least currents in feeders (16A, 16B, 16C) of all phases and a voltage appearing at the neutral point, and initiating fault detection if any measured quantities exceed a predefined threshold value, ***characterised* by** the steps:

   if transient current exceeds fundamental frequency current, use the steps:

   a) estimating capacitance and conductance of each feeder,
   b) estimating capacitance and conductance of the neutral point,
   c) determining a feeder as faulty, either when the capacitance of the feeder is lower than the capacitance of the neutral point device, or when the conductance of the feeder is lower than the conductance of the neutral point device and lower than the conductance of all other feeders;

   if transient current does not exceed fundamental frequency current, use the steps:

   d) determining active power of each feeder
   e) determining a feeder as faulty when the active power of said feeder exceeds a predefined value,
   f) determining the magnitude of the neutral point voltage phasor,
   g) determining a derivative of said magnitude,
   h) using active power to determine a fault direction of each feeder, if said magnitude exceeds a preset threshold and if said derivative is positive and
   i) producing a resulting report signal.

2. A method as claimed in claim 1 including the steps:

   setting a memory element of each feeder with the determined fault direction,
   using a content of said memory element if the magnitude of the neutral point voltage phasor is over a preset threshold value and the derivative of the magnitude of said phasor is below a negative threshold

3. A method as claimed in any of the preceding claims and performing step d) by:
   calculating fundamental frequency phasors of a residual current formed by the sum of phase currents for each feeder and by calculating fundamental frequency phasor of the neutral point voltage.

4. A method as claimed in anyone and any combination of the preceding claims where the values of conductance G and capacitance C, for each feeder and neutral point device are estimated by the steps:

   a) Sample the neutral point voltage, notation $u_k$ and residual current for feeder m, notation $i_{m,k}$, where $k$ is the sample index;

   b) Calculate the voltage derivative approximation, notation $w_k$ from $w_k \approx \frac{1}{h}(u_k - u_{k-1})$ where h is the sampling interval;
   c) Use the latest *n+1* samples *(one extra sample is needed for $w_k$)* to calculate the following intermediate variables

$$A = \sum_{k=1}^{n} u_k^2 \qquad B = \sum_{k=1}^{n} w_k^2 \qquad D = \sum_{k=1}^{n} u_k w_k$$

$$E_m = \sum_{k=1}^{n} u_k i_{m,k} \qquad F_m = \sum_{k=1}^{n} w_k i_{m,k} \ ;$$

d) Calculate the intermediate variable $H$ from $H = AB - D^2$;
e) Calculate the estimated value of conductance $G$ and capacitance $C$, for feeder with index $m$, or neutral point device, from

$$\hat{G}_m = \frac{BE_m - DF_m}{H} \qquad \hat{C}_m = \frac{AF_m - DE_m}{H};$$

**5.** A method as claimed in anyone and any combination of the preceding claims where the values of conductance $G$ and capacitance $C$, for each feeder and neutral point device are estimated by the steps:

a) Sample the neutral point voltage, notation $u_k$ and residual current for feeder $m$, notation $i_{m,k}$, where $k$ is the sample index;

b) Calculate the voltage derivative approximation, notation $w_k$ from $w_k \approx \frac{1}{h}(u_k - u_{k-1})$ where h is the sampling interval;
c) Calculate the following intermediate variables

$$x_A = u_k^2 \qquad x_B = w_k^2 \qquad x_D = u_k w_k$$

$$x_{E_m} = u_k i_{m,k} \qquad x_{F_m} = w_k i_{m,k};$$

d) Use any kind of discrete low pass filter, that can be **characterized by** a rational transfer function, such as,

$$H_{LP}(q) = \frac{B_{LP}(q)}{A_{LP}(q)},$$

where $q$ is the shift operator, and $B_{LP}(q)$ and $A_{LP}(q)$ are polynomials in $q$.
e) Calculate the filtered intermediate variables

$$A = H_{LP}(q) \cdot x_A$$

$$B = H_{LP}(q) \cdot x_B$$

$$D = H_{LP}(q) \cdot x_D$$

$$E_m = H_{LP}(q) \cdot x_{E_m}$$

$$F_m = H_{LP}(q) \cdot x_{F_m};$$

f) Calculate the filtered intermediate variable $H$ from

$$H = AB - D^2;$$

g) Calculate the estimated value of conductance G and capacitance C, for feeder with index m, or neutral point device, from

$$\hat{G}_m = \frac{BE_m - DF_m}{H} \qquad \hat{C}_m = \frac{AF_m - DE_m}{H};$$

**6.** A method as claimed in claim 5, where the steps of estimating the values of conductance G and capacitance C are performed in continuous time.

**7.** A method as claimed in any of claims 4 to 6, estimating the neutral point current $i_N$ from the neutral point voltages $u_0$ as,

$$i_N = H(s) \cdot u_0 ,$$

where *H(s)* is the transfer function for a low-pass filter that models the relation between the two mention quantities. One example of such as filter is,

$$H(s) = \frac{\frac{1}{R}}{(1 + \frac{L}{R}s)}$$

The parameters *L* and *R* can be determined from known, or approximated data for the neutral point device.

**8.** A method as claimed in anyone and any combination of the preceding claims where steps relating to a single feeder is taken by a separate protection device (20).

**9.** A method as claimed in claims 1 to 7 where steps relating to all feeders are taken by an integrated central protection device (24).

**10.** A method as claimed in anyone and any combination of the preceding claims also including the step to continuously record measured and estimated quantities.

**11.** A computer-readable medium having computer programs which when executed by a processor cause an electronic apparatus to perform the earth faults detecting method of any one of claims 1 to 7.

## Patentansprüche

**1.** Verfahren zum Nachweis von Erdfehlern in dreiphasigen elektrischen Energieverteilungsnetzen, aufweisend eine Spule (10), die mit einem Neutralleiter eines Energietransformators (12) verbunden ist,
wobei ein kontinuierliches Messen zumindest der Ströme aller Phasen in den Außenleitern (16A; 16B; 16N) und der am Neutralleiter auftretenden Spannung erfolgt, und
wobei eine schrittweise Fehlererkennung eingeleitet wird, wenn einer der gemessenen Werte einen vordefinierten Schwellenwert überschreitet, **dadurch gekennzeichnet,**
**dass,** wenn der transiente Strom den Grundfrequenzstrom überschreitet, folgende Schritte auszuführen sind:

a) Bestimmen der Kapazität und der Leitfähigkeit jedes Außenleiters,
b) Bestimmen der Kapazität und der Leitfähigkeit des Neutralleiters,
c) Bewerten eines Außenleiters als fehlerhaft, entweder wenn die Kapazität des Außenleiters niedriger ist als die Kapazität des Neutralleiters, oder wenn der Leitwert des Außenleiters niedriger ist als der Leitwert des Neutralleiters und niedriger ist als der Leitwert aller anderen Leiter; und

**dadurch gekennzeichnet,**
**dass,** wenn der transiente Strom den Grundfrequenzstrom nicht überschreitet, folgende Schritte auszuführen sind:

d) Bestimmen der Wirkleistung jedes Außenleiters,
e) Bewerten eines Außenleiters als fehlerhaft, wenn die Wirkleistung des Außenleiters einen vorgegebenen Wert überschreitet,
f) Bestimmen der Größe des Neutralleiter-Spannungsphasors,
g) Bestimmen einer Ableitung der vorgenannten Größe,

h) Verwenden der Wirkleistung zum Bestimmen einer Richtungsabweichung jedes Außenleiters, wenn die genannte Größe einen voreingestellten Schwellenwert überschreitet und wenn die Ableitung positiv ist, und
i) Erzeugen eines resultierenden Berichtssignals.

**2.** Verfahren nach Anspruch 1, umfassend die Schritte:

- Einstellen eines Speicherelements jedes Außenleiters auf die festgelegte Richtungsabweichung,
- Anwenden des Inhalts des genannten Speicherelements, wenn der Wert des Neutralleiter-Spannungsphasors oberhalb eines voreingestellten Schwellenwertes liegt und die Ableitung der Größe des vorgenannten Phasors unterhalb eines negativen Schwellenwertes liegt.

**3.** Verfahren nach einem der vorhergehenden Ansprüche und Durchführen von Schritt d) mittels Berechnen der Grundfrequenz-Phasoren eines Reststroms, der durch die Summe der Phasenströme für jeden Außenleiter gebildet wird, und mittels Berechnen des Grundfrequenz-Phasors der Neutralleiterspannung.

**4.** Verfahren nach einem der vorhergehenden Ansprüche und einer beliebigen Kombination der vorhergehenden Ansprüche, wobei die Werte für den Leitwerts G und für die Kapazität C für jeden Außenleiter und den Neutralleitervorrichtung durch die folgenden Schritte ermittelt werden:

a) Ermitteln der Neutralleiterspannung, Symbol $u_k$, und des Reststroms für Außen-leiter m, Symbol $i_{m,k}$, wobei *k* der Abtast-Index ist;

b) Berechnen der Spannungsableitungsnäherung, Symbol $w_k$, aus $w_k \approx \frac{1}{h}(u_k - u_{k-1})$, wobei *h* das Abtastintervall ist.
c) Verwenden der aktuellsten *n+1* Abtastwerte (*ein zusätzlicher Abtastwert wird für $w_k$ benötigt),* um die folgenden Zwischenvariablen zu berechnen:

$$A = \sum_{k=1}^{n} u_k^2 \qquad B = \sum_{k=1}^{n} w_k^2 \qquad D = \sum_{k=1}^{n} u_k w_k$$

$$E_m = \sum_{k=1}^{n} u_k i_{m,k} \qquad F_m = \sum_{k=1}^{n} w_k i_{m,k} \ ;$$

d) Berechnen der Zwischenvariablen *H* mittels

$$H = AB - D^2 \ ;$$

e) Berechnen des Schätzwertes für den Leitwert G und die Kapazität C, für den Außenleiter mit dem Index m, oder die Neutralleiter-Vorrichtung, mittels

$$\hat{G}_m = \frac{BE_m - DF_m}{H} \qquad \hat{C}_m = \frac{AF_m - DE_m}{H} \ ;$$

**5.** Verfahren nach einem der vorhergehenden Ansprüche und in einer beliebigen Kombination der vorhergehenden Ansprüche, wobei die Werte des Leitwerts G und der Kapazität C für jeden Außenleiter und den Neutralleiter durch folgende Schritte ermit-telt werden:

a) Ermitteln der Neutralleiterspannung, Symbol $u_k$, und des Reststroms für den Außenleiter m, Symbol $i_{m,k}$, wobei *k* der Abtast-Index ist;
b) Berechnen der Spannungsableitungsapproximation, Symbol $w_k$, mittels

$$w_k \approx \frac{1}{h}\,(u_k - u_{k-1})\;,$$

wobei h das Abtastintervall ist;
c) Berechnen der folgenden Zwischenvariablen:

$$x_A = u_k^2 \qquad x_B = w_k^2 \qquad x_D = u_k w_k$$

$$x_{E_m} = u_k i_{m,k} \qquad x_{F_m} = w_k i_{m,k}\;;$$

d) Verwenden einer beliebigen Art von diskretem Tiefpassfilter, welches durch eine rationale Übertragungsfunktion charakterisiert werden kann, wie z. B.

$$H_{LP}(q) = \frac{B_{LP}(q)}{A_{LP}(q)}\,,$$

wobei *q* der Verschiebungsoperator ist, und $B_{LP}(q)$ und $A_{LP}(q)$ Polynome in *q* sind.
e) Berechnen der gefilterten Zwischenvariablen

$$A = H_{LP}(q)\cdot x_A$$

$$B = H_{LP}(q)\cdot x_B$$

$$D = H_{LP}(q)\cdot x_D$$

$$E_m = H_{LP}(q)\cdot x_{E_m}$$

$$F_m = H_{LP}(q)\cdot x_{F_m}\;;$$

f) Berechnen der gefilterten Zwischenvariablen *H* mittels

$$H = AB - D^2;$$

g) Berechnen des Schätzwertes von Leitwert G und Kapazität C, für Außenleiter mit Index m, oder die Neutralleitervorrichtung, mittels

$$\hat{G}_m = \frac{BE_m - DF_m}{H} \qquad \hat{C}_m = \frac{AF_m - DE_m}{H}\;;$$

**6.** Verfahren nach Anspruch 5,
wobei die Schritte zum Ermitteln der Werte der Leitfähigkeit G und der Kapazität C zeitkontinuierlich durchgeführt werden.

**7.** Verfahren nach einem der Ansprüche 4 bis 6,
wobei der Neutralleiterstrom $i_N$ aus den Neutralleiterspannungen $u_0$ ermittelt wird, gemäß

$$i_N = H(s)\cdot u_0\,,$$

wobei *H (s)* die Übertragungsfunktion für ein Tiefpassfilter ist, das die Beziehung zwischen den beiden genannten Größen modelliert. Ein Beispiel für einen solchen Filter ist

$$H(s) = \frac{\frac{1}{R}}{(1 + \frac{L}{R} s)}$$

Die Parameter L und R können aus bekannten oder angenäherten Daten für die Neutralleitervorrichtung bestimmt werden.

**8.** Verfahren nach einem beliebigen oder einer Kombination der vorhergehenden Ansprüche,
wobei die Schritte sich auf einen einzelnen Außenleiter beziehen und durch eine separate Schutzvorrichtung (20) übernommen wird.

**9.** Verfahren nach einem der Ansprüche 1 bis 7,
wobei die Schritte, die sich auf alle Außenleiter beziehen, von einer integrierten zentralen Schutzvorrichtung (24) ausgeführt werden.

**10.** Verfahren nach einem beliebigen oder einer Kombination der vorhergehenden Ansprüche,
wobei es auch den Schritt zum kontinuierlichen Aufzeichnen von gemessenen und geschätzten Werten aufweist.

**11.** Computerlesbares Medium mit Computerprogrammen, die, wenn sie von einem Prozessor ausgeführt werden, eine elektronische Vorrichtung veranlassen, das Erdfehlerdetektionsverfahren nach einem der Ansprüche 1 bis 7 auszuführen.

## Revendications

**1.** Procédé de détection de défauts à la terre dans un réseau de distribution de puissance électrique triphasé comprenant une bobine (10) reliée à un point neutre d'un transformateur de puissance (12), incluant le fait de mesurer en continu au moins des intensités de courant dans des lignes d'alimentation (16A, 16B, 16C) de toutes les phases et une tension apparaissant au point neutre, et le fait d'initier une détection de défauts si les grandeurs mesurées dépassent une valeur de seuil prédéfinie, **caractérisé par** les étapes consistant à :

si l'intensité du courant transitoire dépasse l'intensité du courant de fréquence fondamentale, utiliser les étapes consistant à :

a) estimer la capacité et la conductance de chaque ligne d'alimentation,
b) estimer la capacité et la conductance du point neutre,
c) considérer une ligne d'alimentation comme défectueuse, lorsque la capacité de la ligne d'alimentation est inférieure à la capacité du dispositif de point neutre, ou lorsque la conductance de la ligne d'alimentation est inférieure à la conductance du dispositif de point neutre et inférieure à la conductance de toutes les autres lignes d'alimentation ;

si l'intensité du courant transitoire ne dépasse pas l'intensité du courant de fréquence fondamentale, utiliser les étapes consistant à :

d) déterminer la puissance active de chaque ligne d'alimentation,
e) considérer une ligne d'alimentation comme défectueuse, lorsque la puissance active de ladite ligne d'alimentation dépasse une valeur prédéfinie,
f) déterminer l'amplitude du phaseur de tension de point neutre,
g) déterminer une dérivée de ladite amplitude,
h) utiliser la puissance active pour déterminer un sens de défaut de chaque ligne d'alimentation, si ladite amplitude dépasse un seuil préétabli et si ladite dérivée est positive et
i) produire un signal de transmission de résultat.

**2.** Procédé selon la revendication 1, incluant les étapes consistant à :

paramétrer un élément de mémoire de chaque ligne d'alimentation avec le sens de défaut déterminé, utiliser un contenu dudit élément de mémoire si l'amplitude du phaseur de tension de point neutre est supérieure à une valeur de seuil préétablie et si la dérivée de l'amplitude dudit phaseur est inférieure à un seuil négatif.

**3.** Procédé selon l'une quelconque des revendications précédentes, et mettant en oeuvre l'étape d) en : calculant des phaseurs de fréquence fondamentale de l'intensité d'un courant résiduel formé par la somme des courants de phase pour chaque ligne d'alimentation et en calculant un phaseur de fréquence fondamentale de la tension de point neutre.

**4.** Procédé selon l'une quelconque et toute combinaison des revendications précédentes, où les valeurs de conductance *G* et de capacité *C,* pour chaque ligne d'alimentation et dispositif de point neutre sont estimées par les étapes consistant à :

a) échantillonner la tension de point neutre, notée $u_k$, et l'intensité de courant résiduel pour une ligne d'alimentation *m*, notée $i_{m.k}$, où *k* est l'indice de l'échantillon ;
b) calculer l'estimation de dérivée de tension, notée $w_k$, d'après la formule

$$w_k \approx \frac{1}{h}(u_k - u_{k-1})$$

où *h* est l'intervalle d'échantillonnage ;
c) utiliser les derniers échantillons *n+1* (un échantillon supplémentaire est nécessaire pour $w_k$) pour calculer les variables intermédiaires suivantes

$$A = \sum_{k=1}^{n} u_k^2 \qquad B = \sum_{k=1}^{n} w_k^2 \qquad D = \sum_{k=1}^{n} u_k w_k$$

$$E_m = \sum_{k=1}^{n} u_k i_{m,k} \qquad F_m = \sum_{k=1}^{n} w_k i_{m,k} \;;$$

d) calculer la variable intermédiaire *H* d'après la formule

$$H = AB - D^2\;;$$

e) calculer la valeur estimée de conductance *G* et de capacité *C,* pour une ligne d'alimentation d'indice *m*, ou un dispositif de point neutre, d'après les formules

$$\hat{G}_m = \frac{BE_m - DF_m}{H} \qquad \hat{C}_m = \frac{AF_m - DE_m}{H}\;.$$

**5.** Procédé selon l'une quelconque et toute combinaison des revendications précédentes, où les valeurs de conductance *G* et de capacité *C,* pour chaque ligne d'alimentation et dispositif de point neutre sont estimées par les étapes consistant à :

a) échantillonner la tension de point neutre, notée $u_k$, et l'intensité de courant résiduel pour une ligne d'alimentation *m*, notée $i_{m.k}$, où *k* est l'indice de l'échantillon ;
b) calculer l'estimation de dérivée de tension, notée $w_k$, d'après la formule

$$w_k \approx \frac{1}{h}(u_k - u_{k-1})$$

où *h* est l'intervalle d'échantillonnage ;

c) calculer les variables intermédiaires suivantes

$$x_A = u_k^2 \qquad x_B = w_k^2 \qquad x_D = u_k w_k$$

$$x_{E_m} = u_k i_{m,k} \qquad x_{F_m} = w_k i_{m,k} \,;$$

d) utiliser tout type de filtre passe-bas discret, qui peut être **caractérisé par** une fonction de transfert rationnelle, telle que

$$H_{LP}(q) = \frac{B_{LP}(q)}{A_{LP}(q)},$$

où $q$ est l'opérateur de décalage, et $B_{LP}(q)$ et $A_{LP}(q)$ sont des polynômes de $q$ ;
e) calculer les variables intermédiaires filtrées

$$A = H_{LP}(q) \cdot x_A$$

$$B = H_{LP}(q) \cdot x_B$$

$$D = H_{LP}(q) \cdot x_D$$

$$E_m = H_{LP}(q) \cdot x_{E_m}$$

$$F_m = H_{LP}(q) \cdot x_{F_m} \,;$$

f) calculer la variable intermédiaire filtrée $H$ d'après la formule

$$H = AB - D^2 \,;$$

g) calculer la valeur estimée de conductance $G$ et de capacité $C$, pour une ligne d'alimentation d'indice $m$, ou un dispositif de point neutre, d'après les formules

$$\hat{G}_m = \frac{BE_m - DF_m}{H} \qquad \hat{C}_m = \frac{AF_m - DE_m}{H} \,.$$

**6.** Procédé selon la revendication 5, où les étapes d'estimation des valeurs de conductance G et de capacité C sont réalisées en continu.

**7.** Procédé selon l'une quelconque des revendications 4 à 6, permettant d'estimer l'intensité de courant de point neutre $i_N$ à partir des tensions de point neutre $u_0$ d'après la formule

$$i_N = H(s) \cdot u_0 \,,$$

où $H(s)$ est la fonction de transfert d'un filtre passe-bas qui modélise la relation entre les deux grandeurs mentionnées, un exemple d'un tel filtre étant

$$H(s) = \frac{\frac{1}{R}}{(1 + \frac{L}{R} s)}$$

les paramètres L et R pouvant être déterminés à partir de données connues ou estimées pour le dispositif de point neutre.

**8.** Procédé selon l'une quelconque et toute combinaison des revendications précédentes, où les étapes ne concernant qu'une seule ligne d'alimentation sont prises en charge par un dispositif de protection distinct (20).

**9.** Procédé selon l'une des revendications 1 à 7, où les étapes concernant toutes les lignes d'alimentation sont prises en charge par un dispositif de protection central intégré (24).

**10.** Procédé selon l'une quelconque et toute combinaison des revendications précédentes, incluant également l'étape consistant à enregistrer en continu les grandeurs mesurées et estimées.

**11.** Support lisible par un ordinateur présentant des programmes informatiques lesquels, lorsqu'ils sont exécutés par un processeur, amènent un appareil électronique à mettre en oeuvre le procédé de détection de défauts à la terre selon l'une quelconque des revendications 1 à 7.

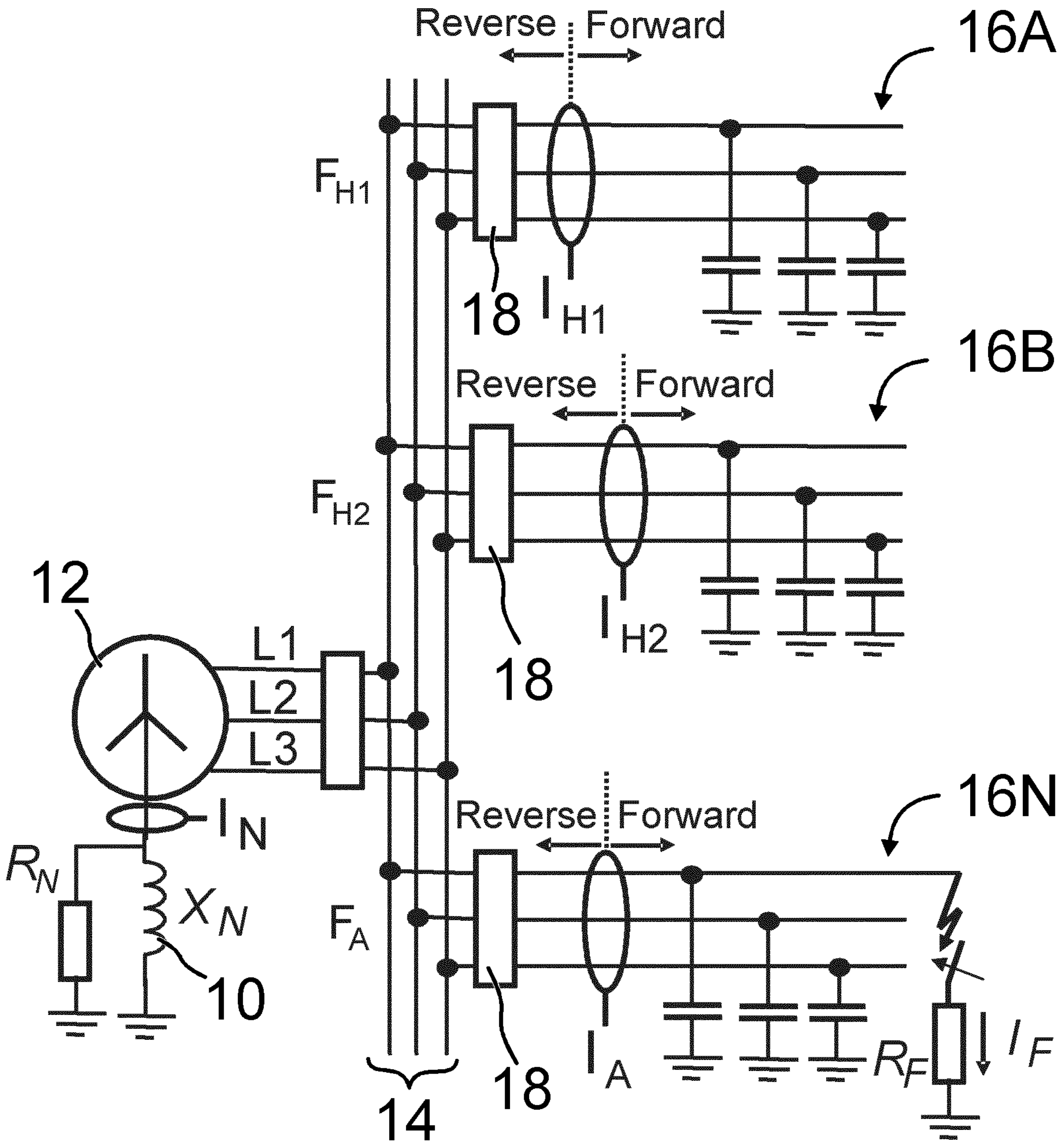
Reverse
Forward
16A
F H1
18
I H1
Reverse
Forward
16B
F H2
18
I H2
12
L1
L2
L3
I N
R N
X N
10
Reverse
Forward
16N
F A
18
I A
R F
I F
14

Fig 1

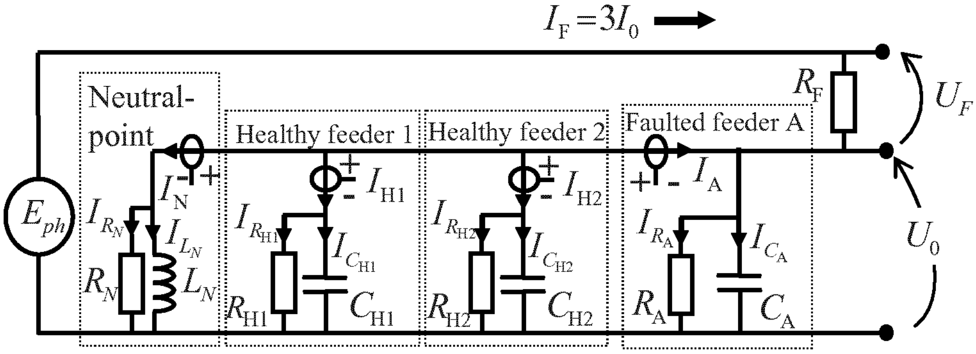

$I_F = 3I_0$
$R_F$
$U_F$
Neutral-point
Healthy feeder 1
Healthy feeder 2
Faulted feeder A
$I_N$
$I_{H1}$
$I_{H2}$
$I_A$
$E_{ph}$
$I_{R_N}$
$I_{L_N}$
$R_N$
$L_N$
$I_{R_{H1}}$
$I_{C_{H1}}$
$R_{H1}$
$C_{H1}$
$I_{R_{H2}}$
$I_{C_{H2}}$
$R_{H2}$
$C_{H2}$
$I_{R_A}$
$I_{C_A}$
$R_A$
$C_A$
$U_0$


Fig 2

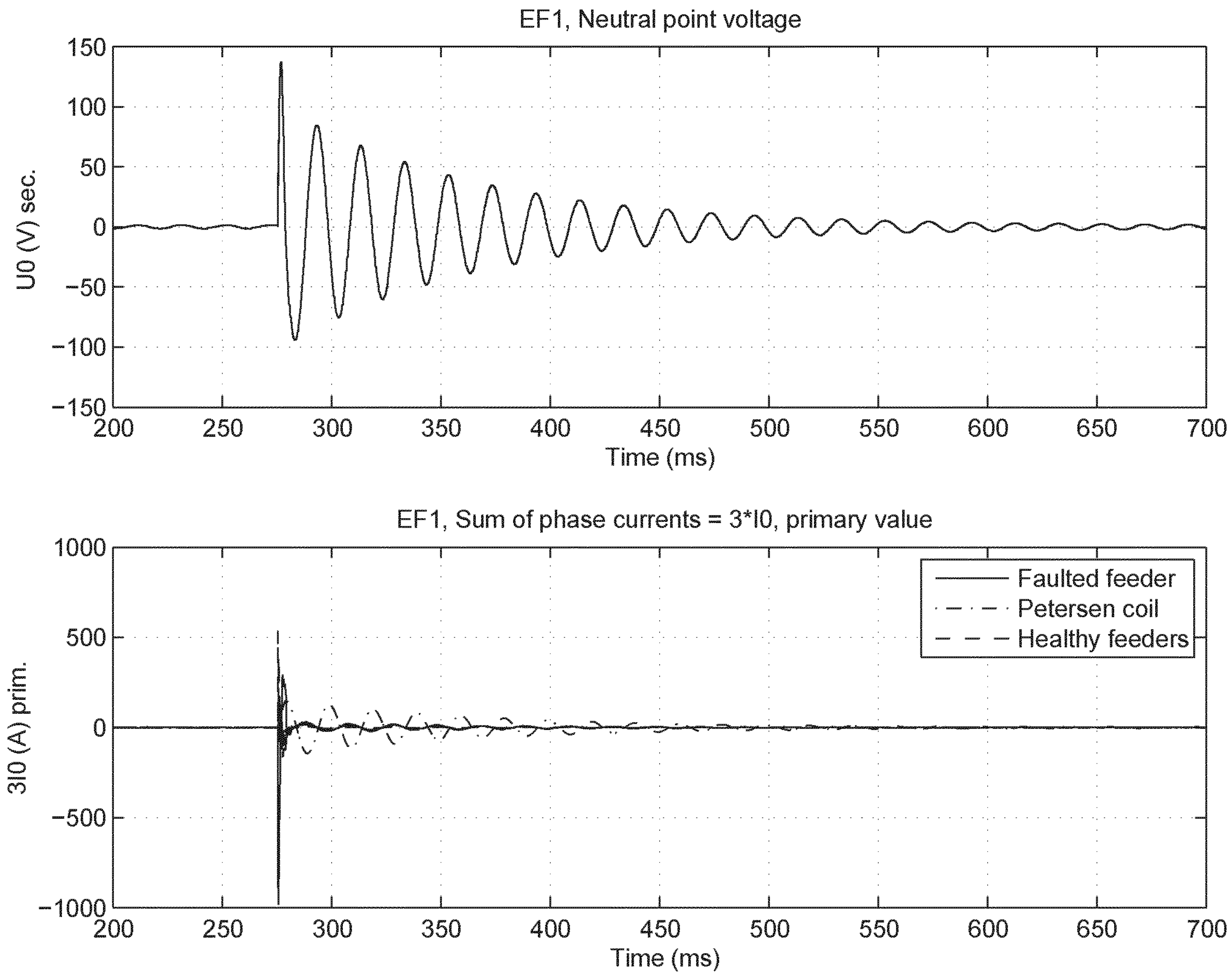
EF1, Neutral point voltage
U0 (V) sec.
150
100
50
0
−50
−100
−150
200
250
300
350
400
450
500
550
600
650
700
Time (ms)
EF1, Sum of phase currents = 3*I0, primary value
3I0 (A) prim.
1000
500
0
−500
−1000
Faulted feeder
Petersen coil
Healthy feeders
Time (ms)

Fig 3A

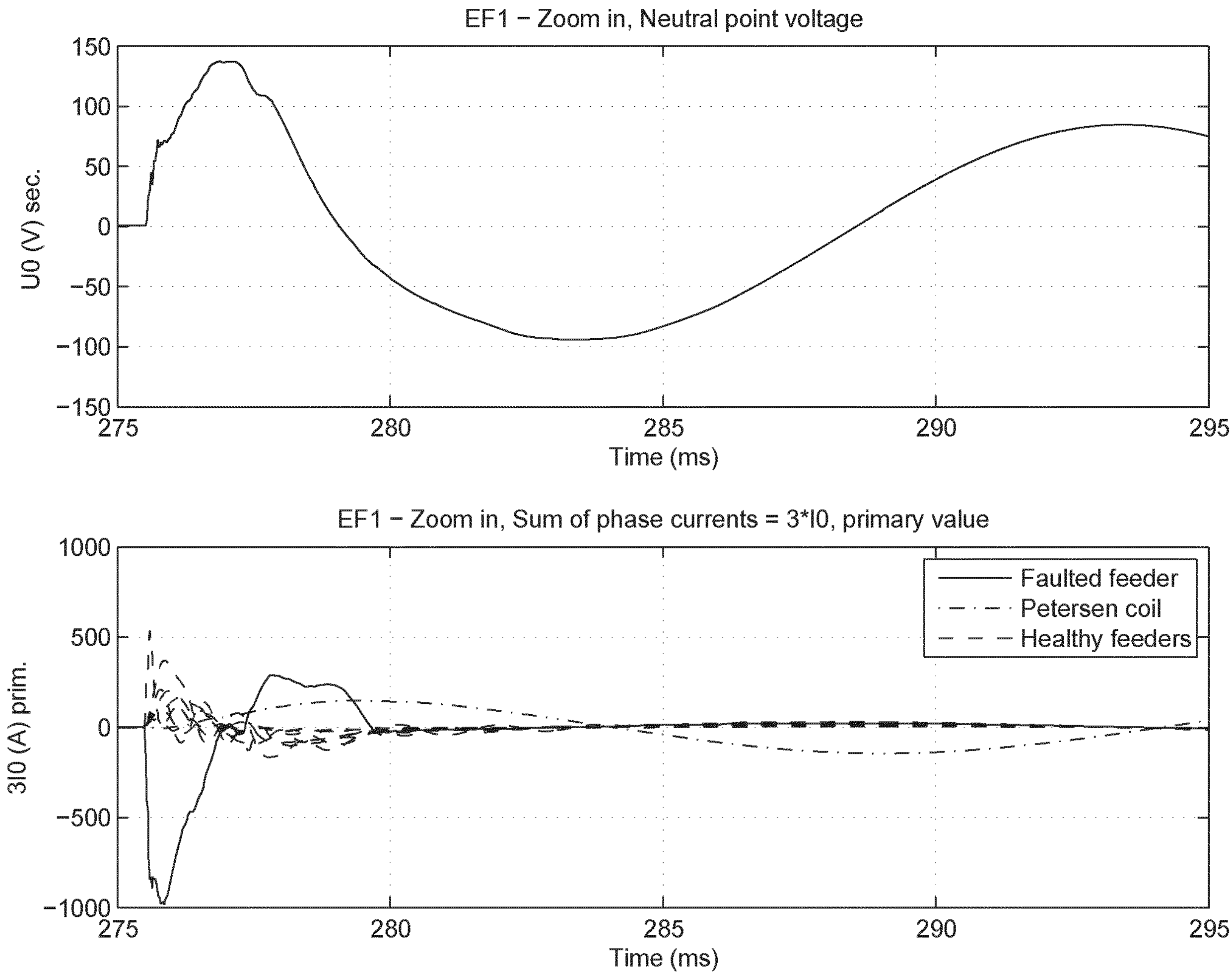
EF1 − Zoom in, Neutral point voltage
U0 (V) sec.
150
100
50
0
−50
−100
−150
275
280
285
290
295
Time (ms)
EF1 − Zoom in, Sum of phase currents = 3*I0, primary value
3I0 (A) prim.
1000
500
0
−500
−1000
Faulted feeder
Petersen coil
Healthy feeders
275
280
285
290
295
Time (ms)

Fig 3B

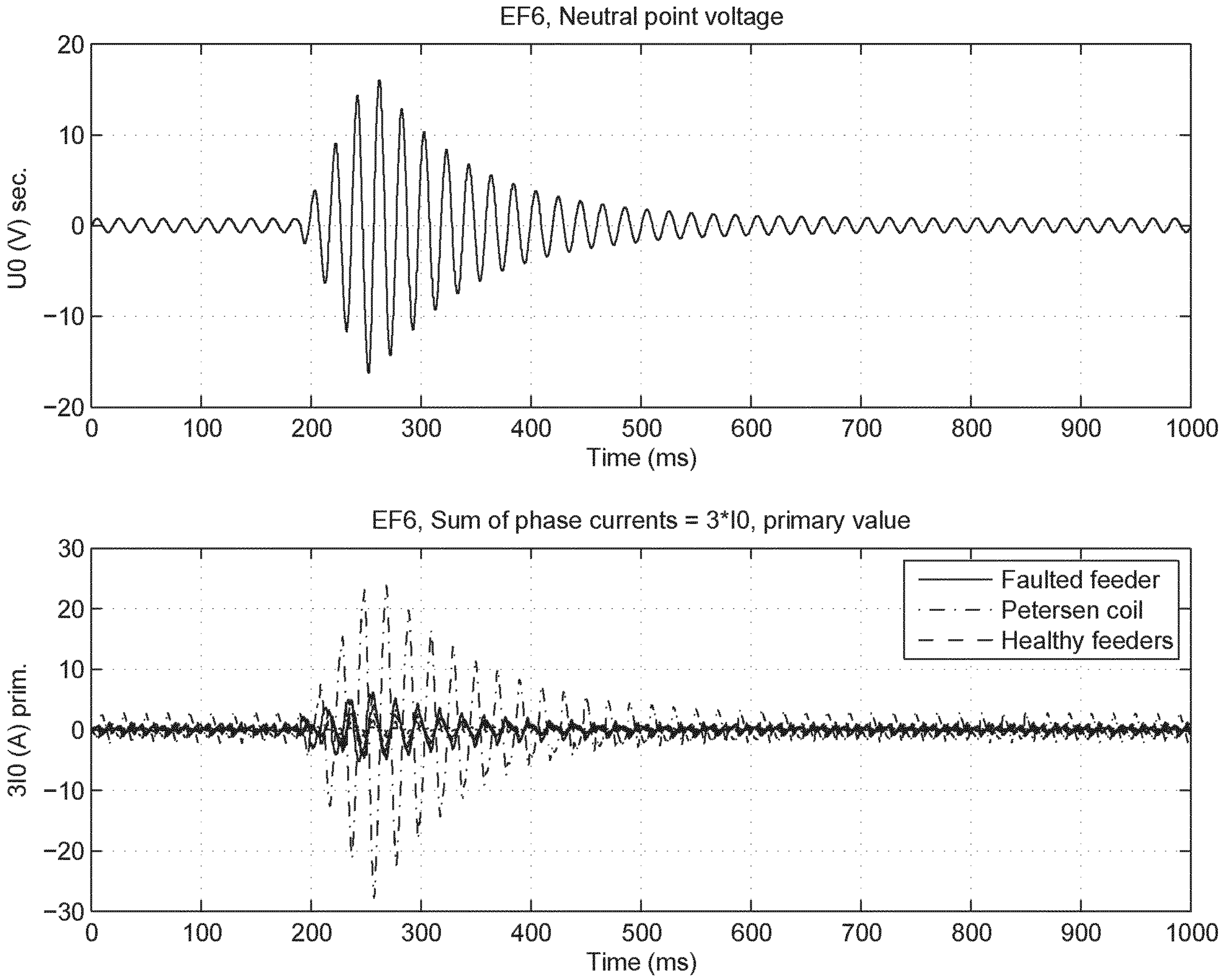
EF6, Neutral point voltage
U0 (V) sec.
20
10
0
−10
−20
0
100
200
300
400
500
600
700
800
900
1000
Time (ms)
EF6, Sum of phase currents = 3*I0, primary value
3I0 (A) prim.
30
20
10
0
−10
−20
−30
Faulted feeder
Petersen coil
Healthy feeders
Time (ms)

Fig 4A

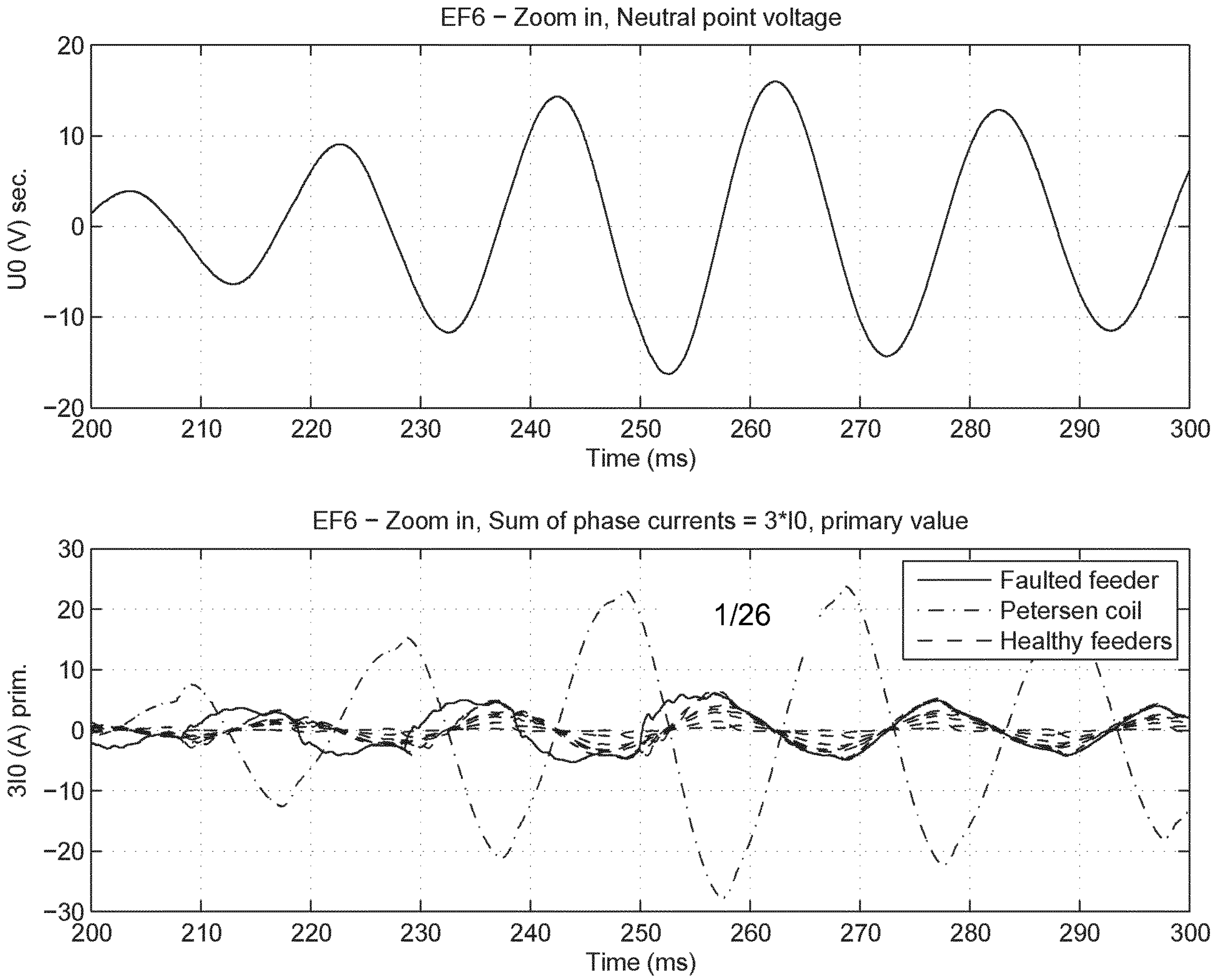
EF6 − Zoom in, Neutral point voltage
U0 (V) sec.
20
10
0
−10
−20
200
210
220
230
240
250
260
270
280
290
300
Time (ms)
EF6 − Zoom in, Sum of phase currents = 3*I0, primary value
3I0 (A) prim.
30
20
10
0
−10
−20
−30
1/26
Faulted feeder
Petersen coil
Healthy feeders
Time (ms)

# Fig 4B

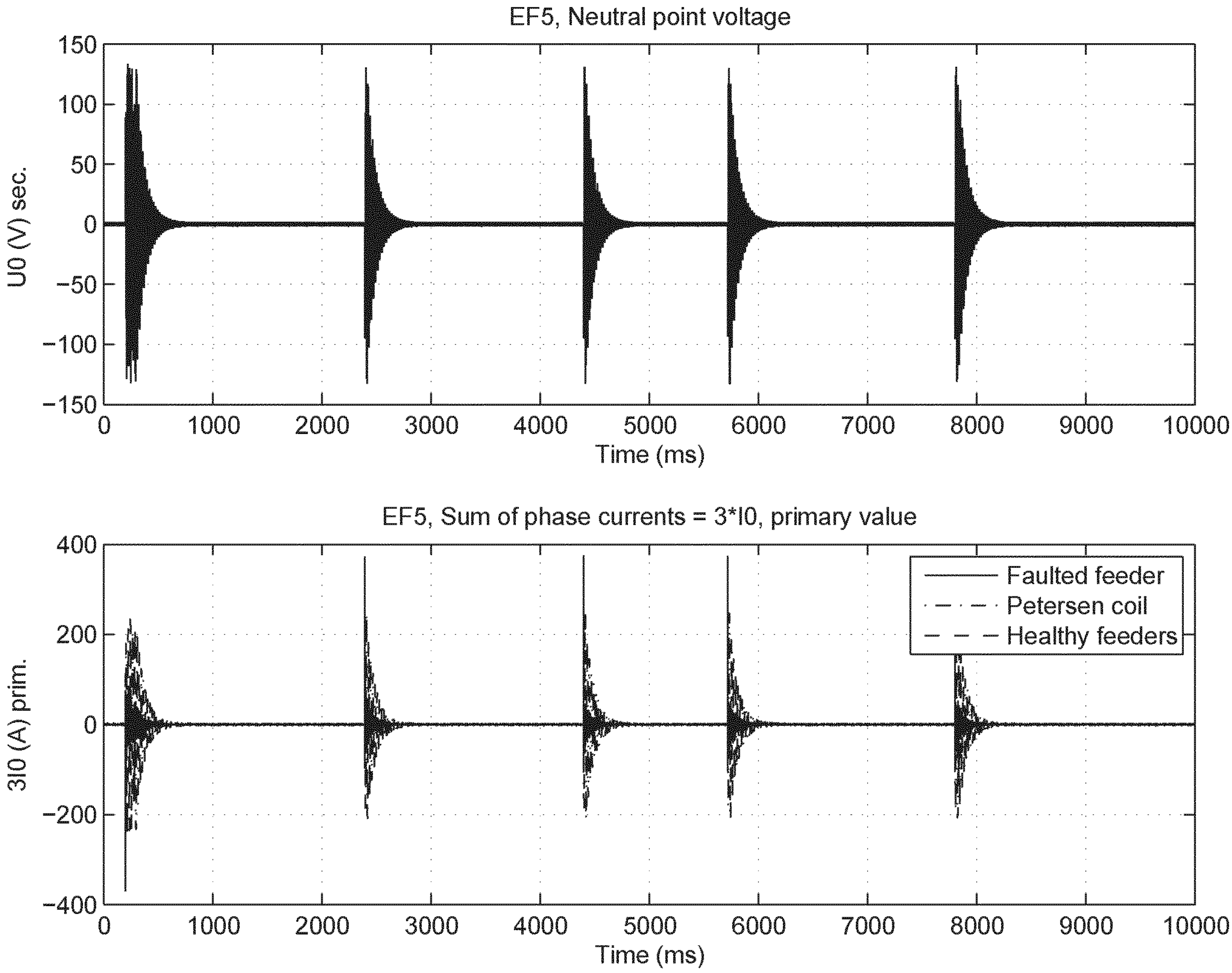
EF5, Neutral point voltage
U0 (V) sec.
150
100
50
0
−50
−100
−150
0
1000
2000
3000
4000
5000
6000
7000
8000
9000
10000
Time (ms)
EF5, Sum of phase currents = 3*I0, primary value
3I0 (A) prim.
400
200
0
−200
−400
0
1000
2000
3000
4000
5000
6000
7000
8000
9000
10000
Time (ms)
Faulted feeder
Petersen coil
Healthy feeders

Fig 5A

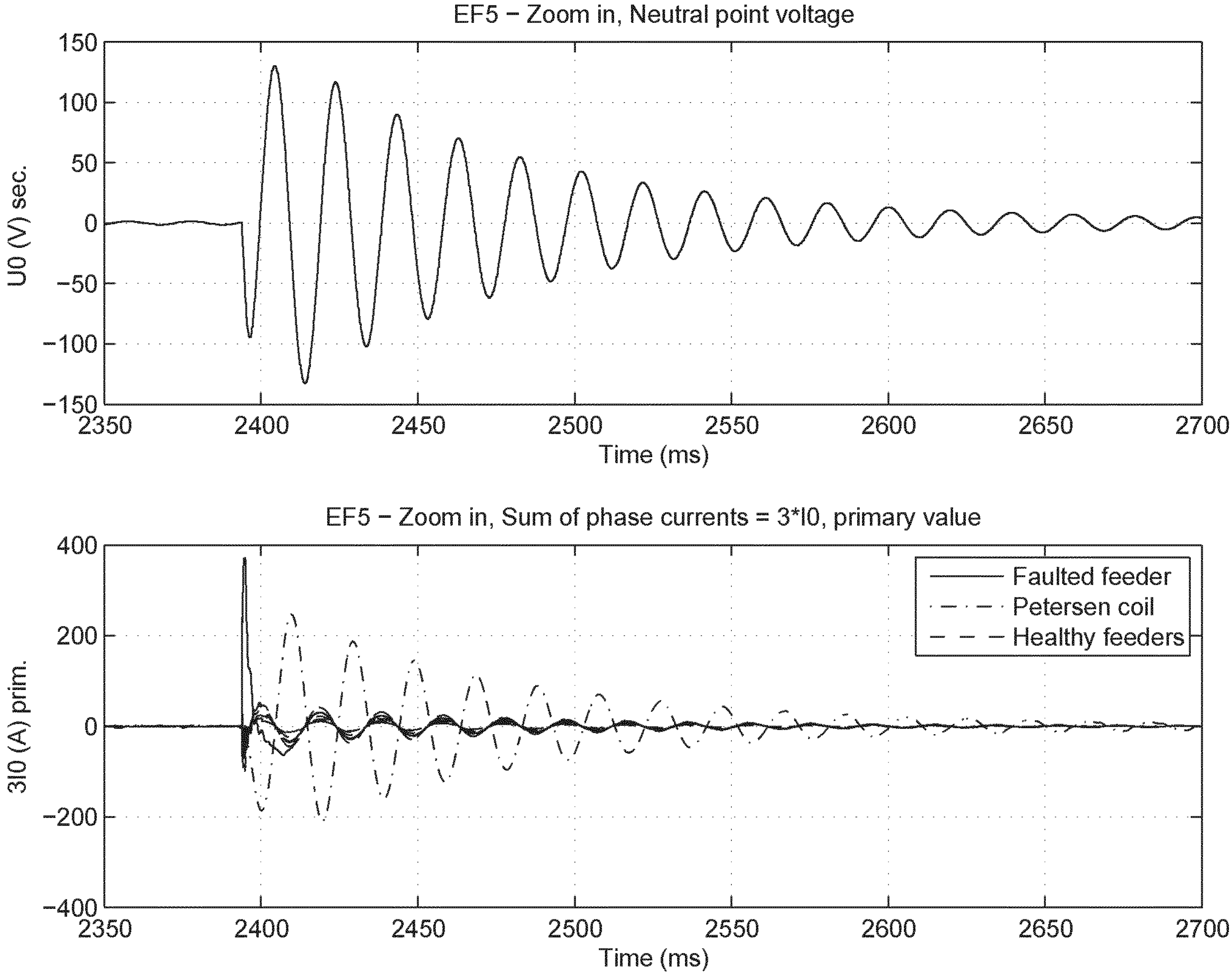
EF5 − Zoom in, Neutral point voltage
U0 (V) sec.
150
100
50
0
−50
−100
−150
2350
2400
2450
2500
2550
2600
2650
2700
Time (ms)
EF5 − Zoom in, Sum of phase currents = 3*I0, primary value
3I0 (A) prim.
400
200
0
−200
−400
Faulted feeder
Petersen coil
Healthy feeders

Fig 5B

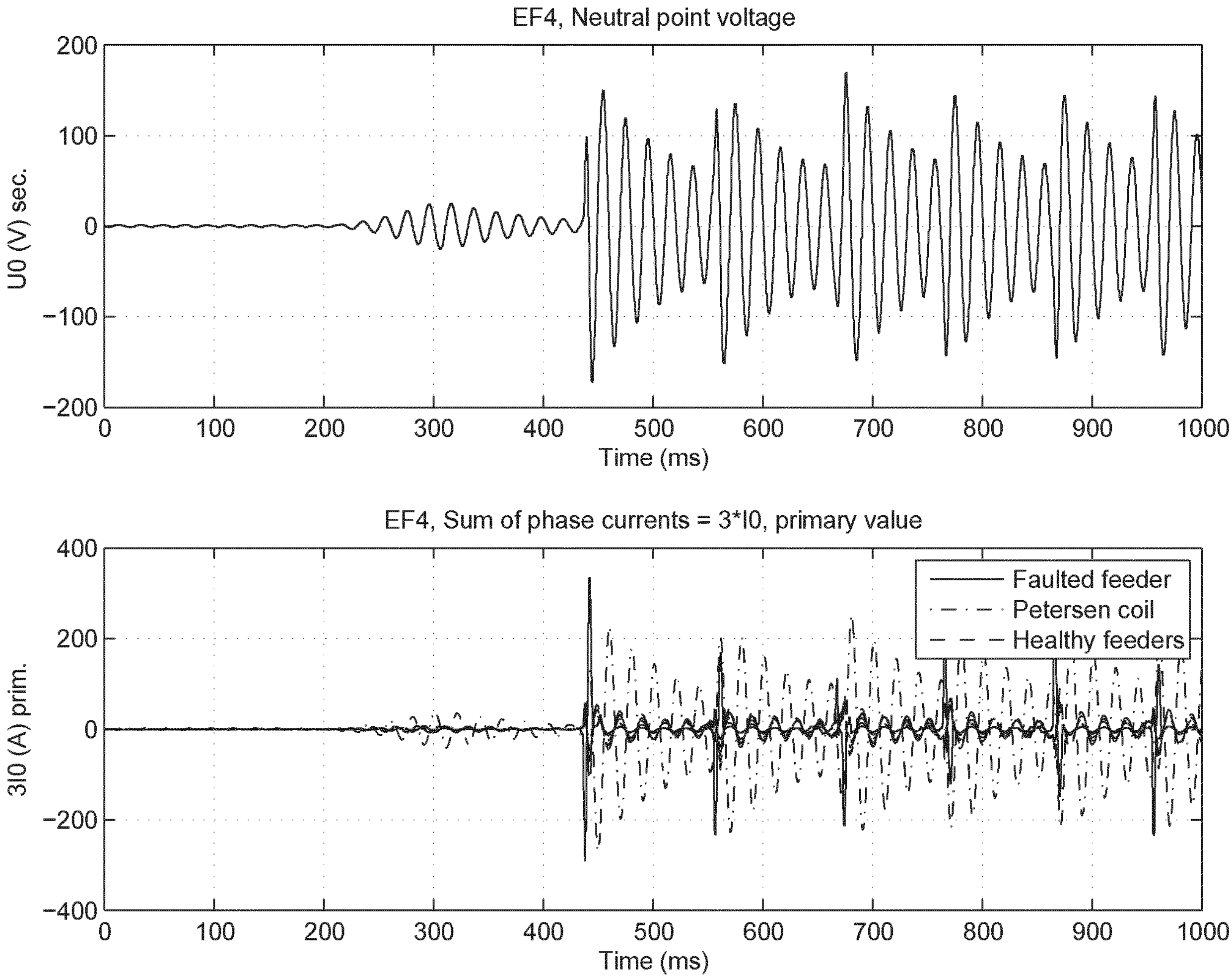
EF4, Neutral point voltage
U0 (V) sec.
200
100
0
−100
−200
0
100
200
300
400
500
600
700
800
900
1000
Time (ms)
EF4, Sum of phase currents = 3*I0, primary value
3I0 (A) prim.
400
200
0
−200
−400
Faulted feeder
Petersen coil
Healthy feeders
Time (ms)

Fig 6A

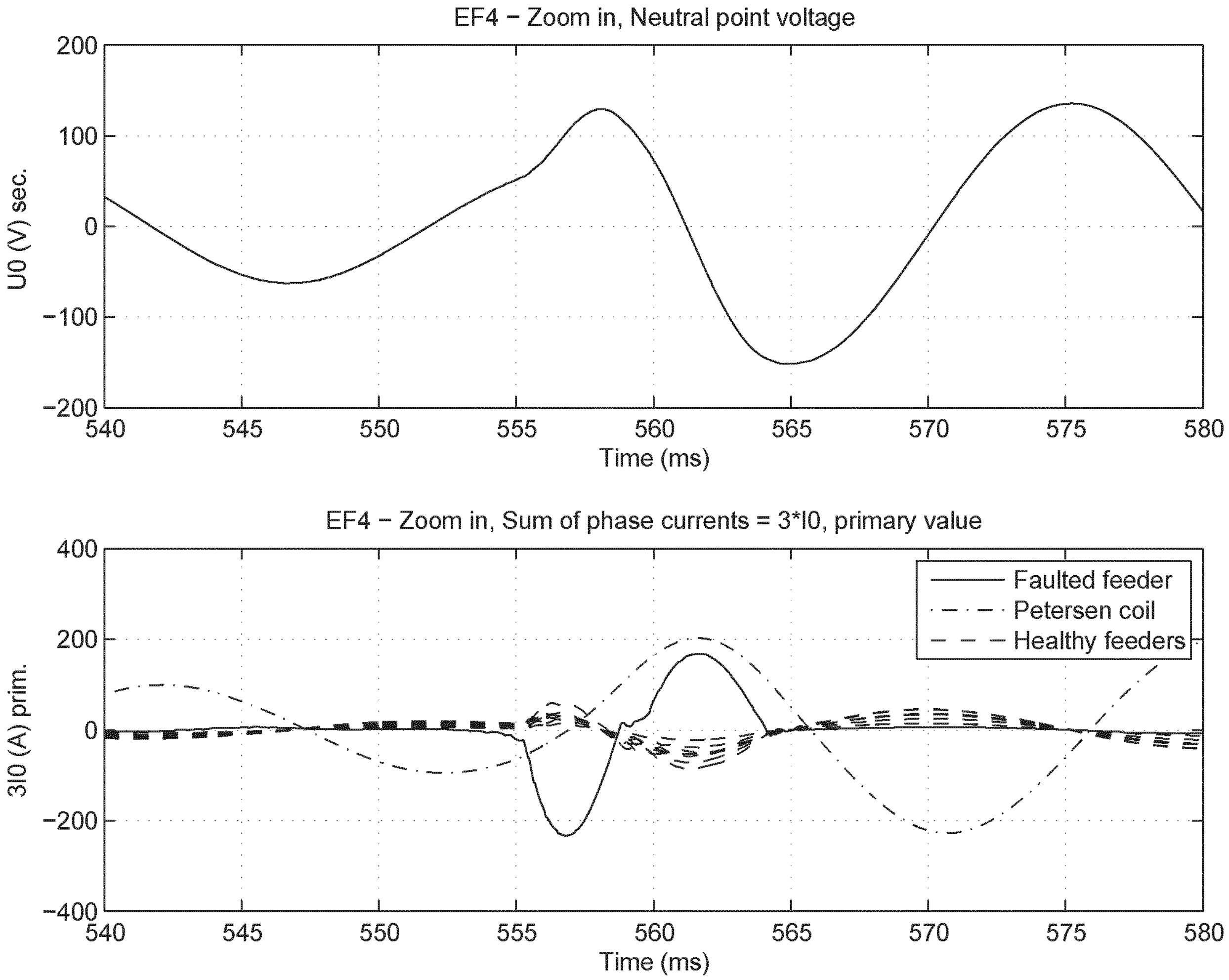
EF4 − Zoom in, Neutral point voltage
200
100
0
−100
−200
U0 (V) sec.
540
545
550
555
560
565
570
575
580
Time (ms)
EF4 − Zoom in, Sum of phase currents = 3*I0, primary value
400
200
0
−200
−400
3I0 (A) prim.
Faulted feeder
Petersen coil
Healthy feeders
540
545
550
555
560
565
570
575
580
Time (ms)

Fig 6B

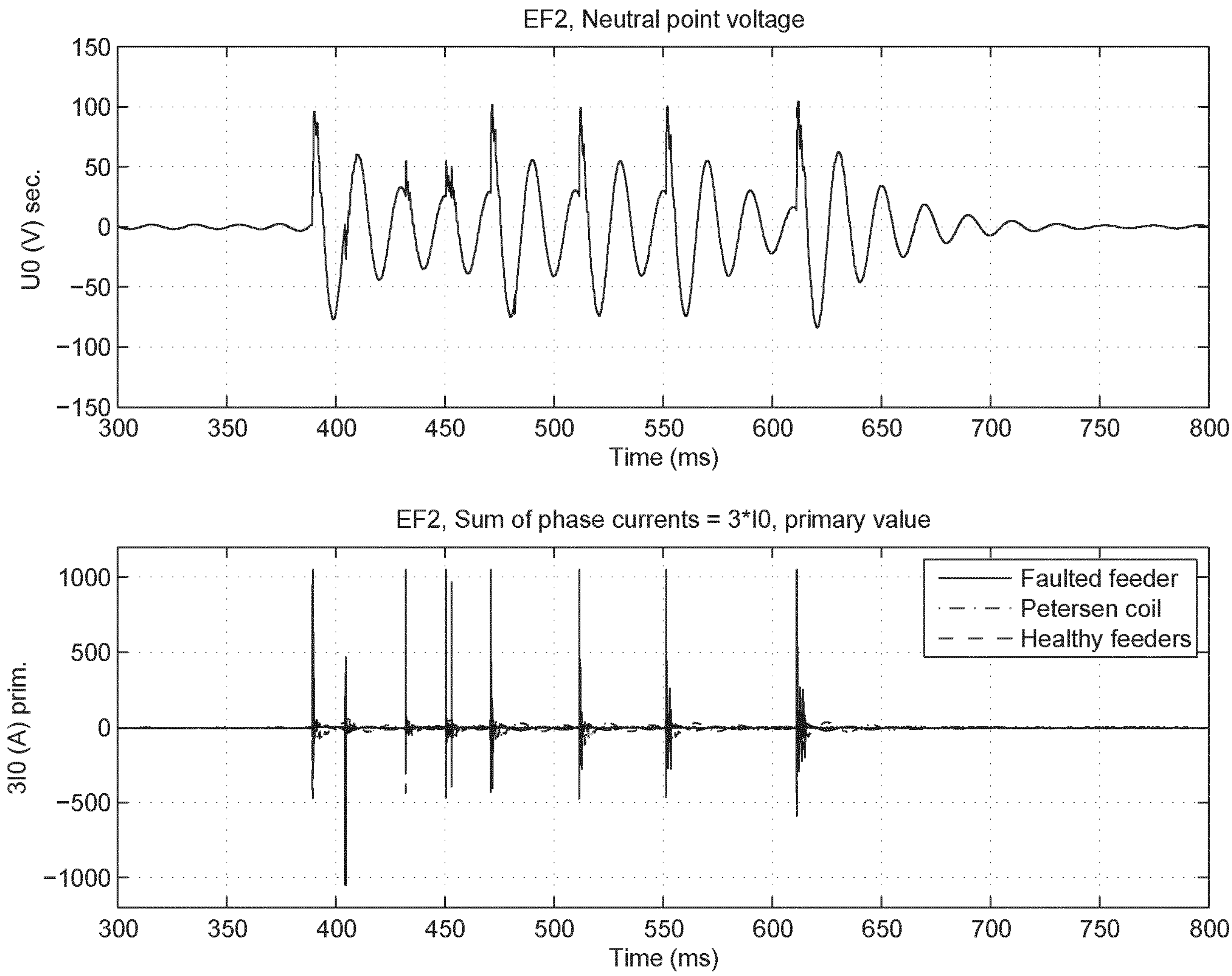
EF2, Neutral point voltage
150
100
50
0
−50
−100
−150
U0 (V) sec.
300
350
400
450
500
550
600
650
700
750
800
Time (ms)
EF2, Sum of phase currents = 3*I0, primary value
1000
500
0
−500
−1000
3I0 (A) prim.
300
350
400
450
500
550
600
650
700
750
800
Time (ms)
Faulted feeder
Petersen coil
Healthy feeders

Fig 7A

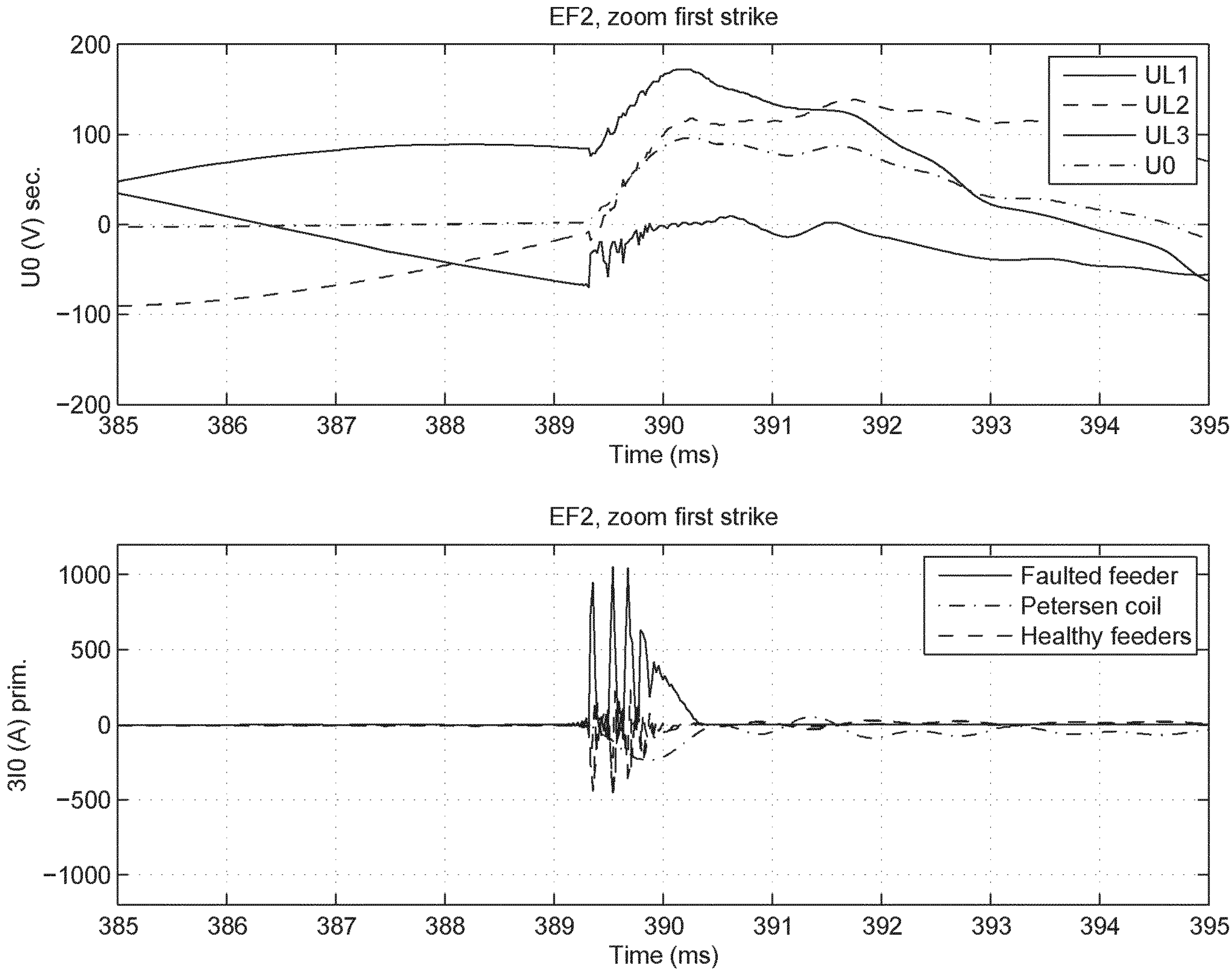
EF2, zoom first strike
U0 (V) sec.
200
100
0
−100
−200
UL1
UL2
UL3
U0
385
386
387
388
389
390
391
392
393
394
395
Time (ms)
EF2, zoom first strike
3I0 (A) prim.
1000
500
0
−500
−1000
Faulted feeder
Petersen coil
Healthy feeders
385
386
387
388
389
390
391
392
393
394
395
Time (ms)

Fig 7B

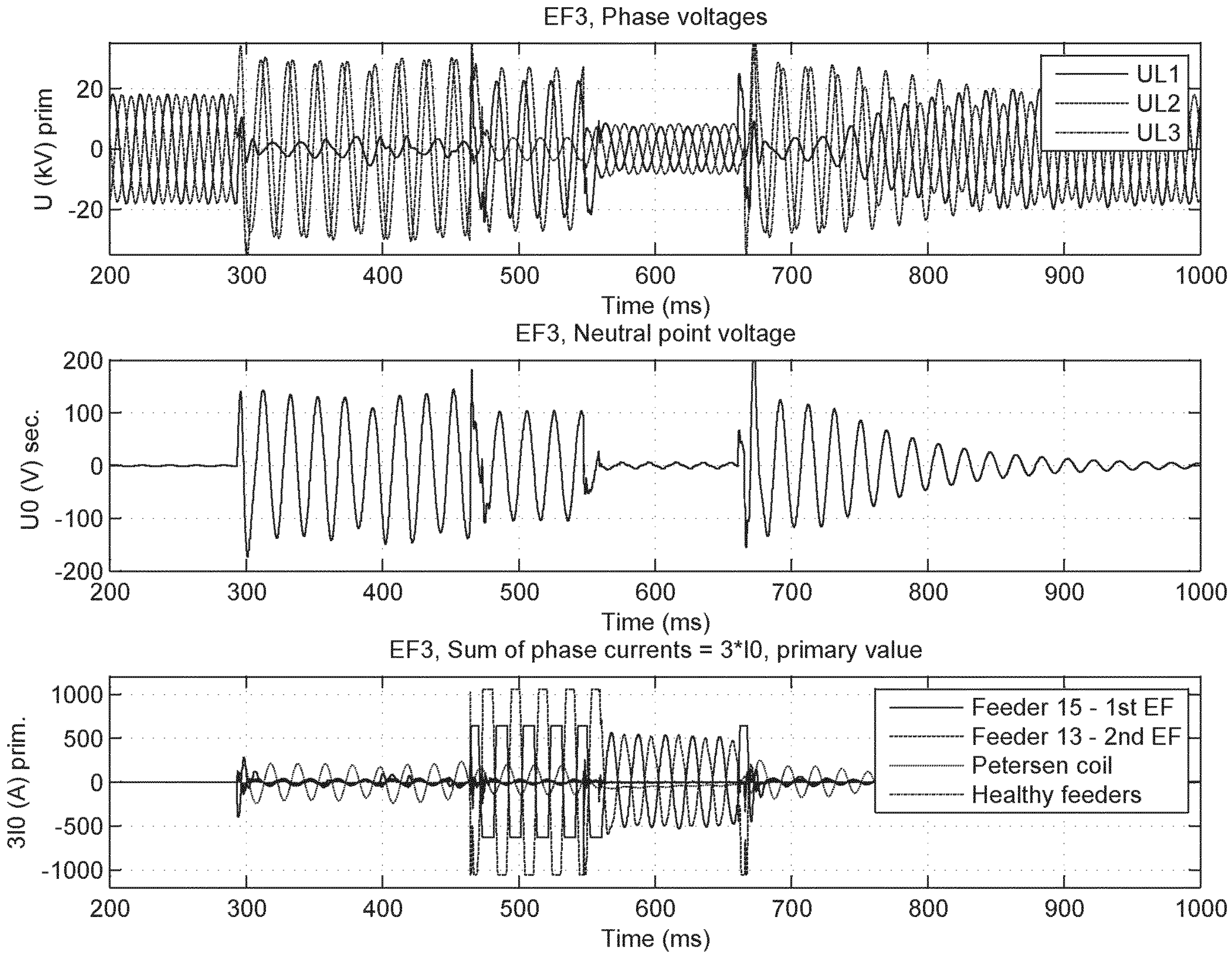

EF3, Phase voltages
U (kV) prim
20
0
-20
200
300
400
500
600
700
800
900
1000
Time (ms)
UL1
UL2
UL3
EF3, Neutral point voltage
U0 (V) sec.
200
100
0
-100
-200
Time (ms)
EF3, Sum of phase currents = 3*I0, primary value
3I0 (A) prim.
1000
500
0
-500
-1000
Time (ms)
Feeder 15 - 1st EF
Feeder 13 - 2nd EF
Petersen coil
Healthy feeders


Fig 8A

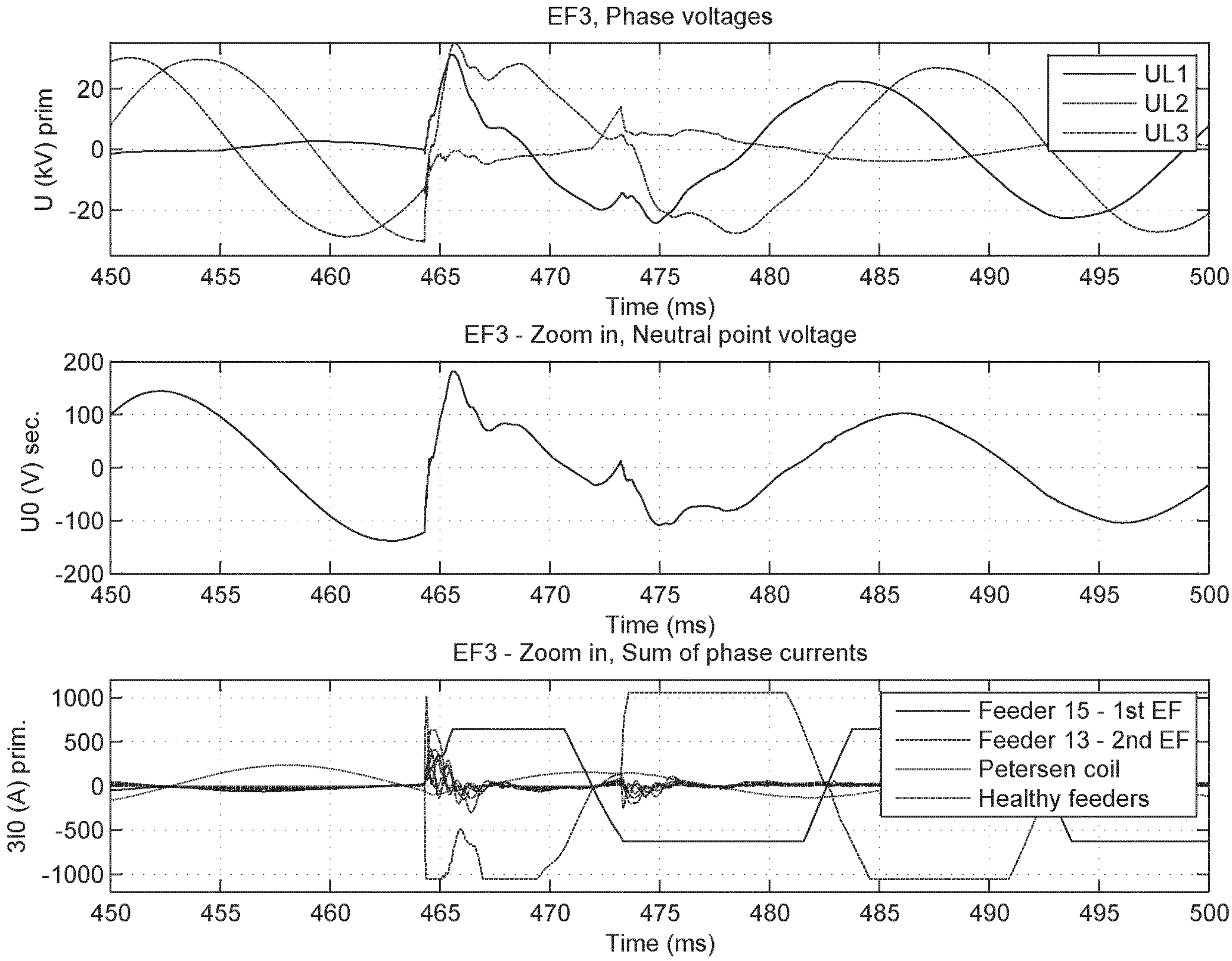
EF3, Phase voltages
U (kV) prim
20
0
-20
UL1
UL2
UL3
450
455
460
465
470
475
480
485
490
495
500
Time (ms)
EF3 - Zoom in, Neutral point voltage
U0 (V) sec.
200
100
0
-100
-200
Time (ms)
EF3 - Zoom in, Sum of phase currents
3I0 (A) prim.
1000
500
0
-500
-1000
Feeder 15 - 1st EF
Feeder 13 - 2nd EF
Petersen coil
Healthy feeders
Time (ms)

Fig 8B

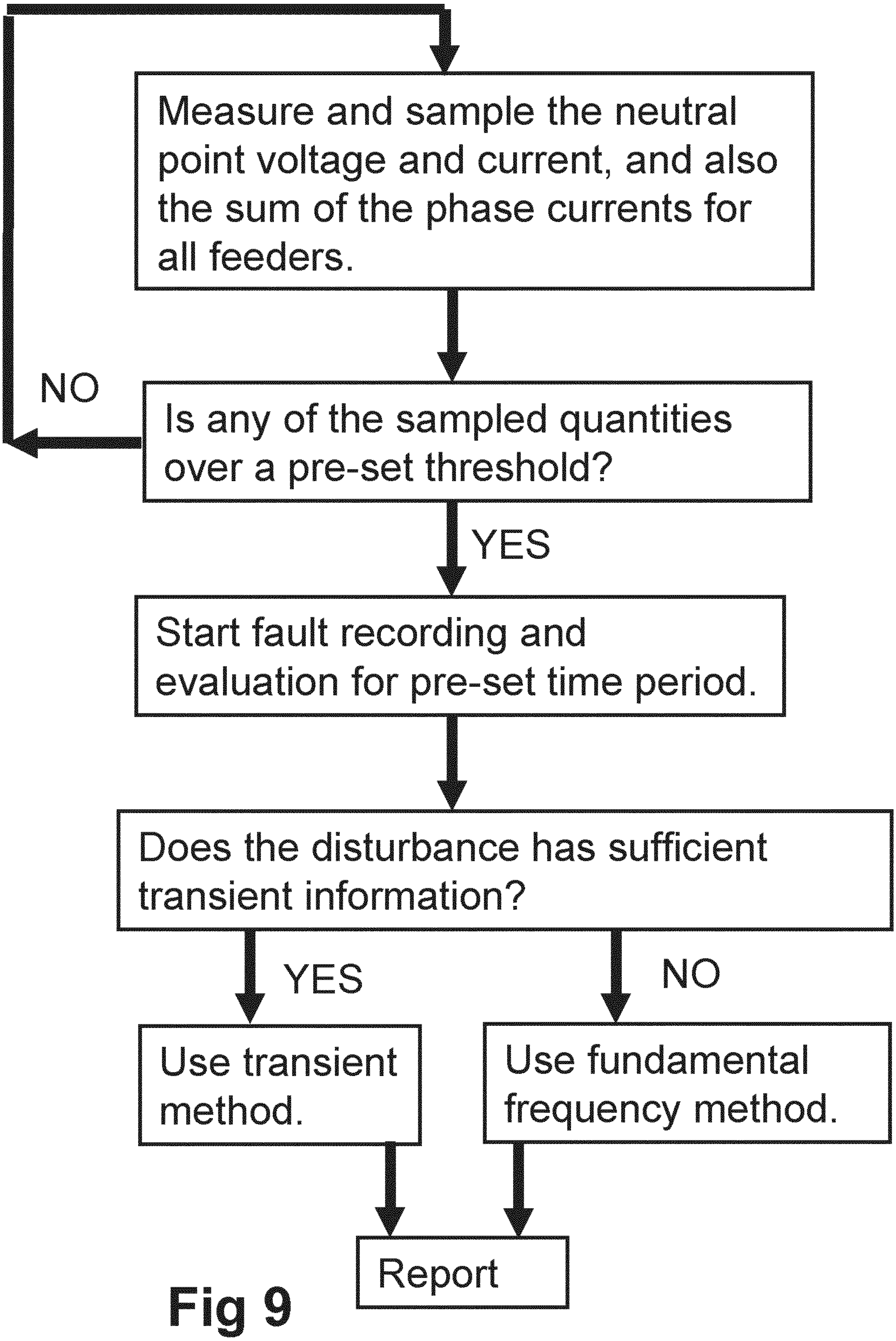
Measure and sample the neutral point voltage and current, and also the sum of the phase currents for all feeders.
NO
Is any of the sampled quantities over a pre-set threshold?
YES
Start fault recording and evaluation for pre-set time period.
Does the disturbance has sufficient transient information?
YES
NO
Use transient method.
Use fundamental frequency method.
Report

Fig 9

# Implementation of transient method

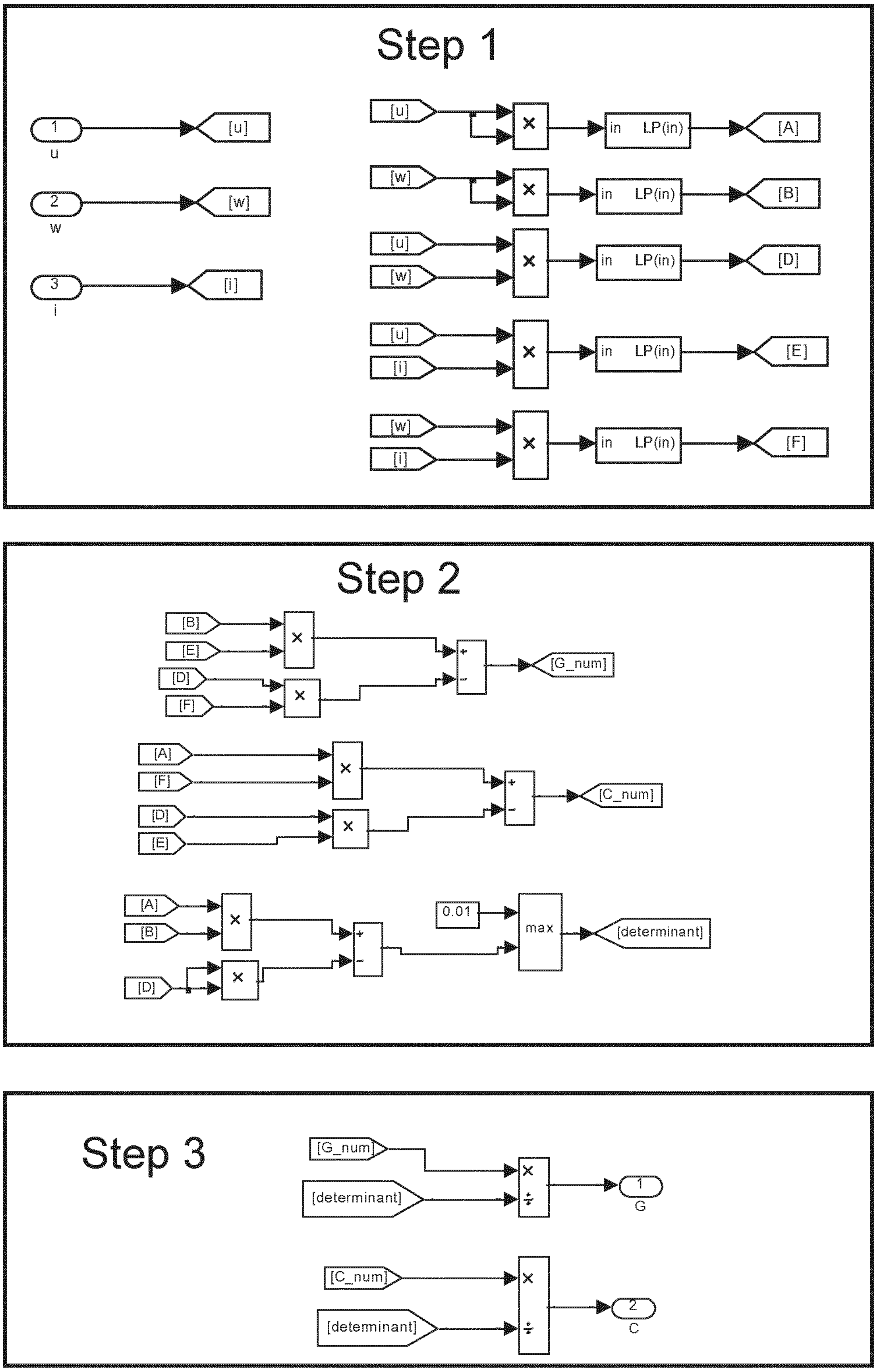


Fig 10

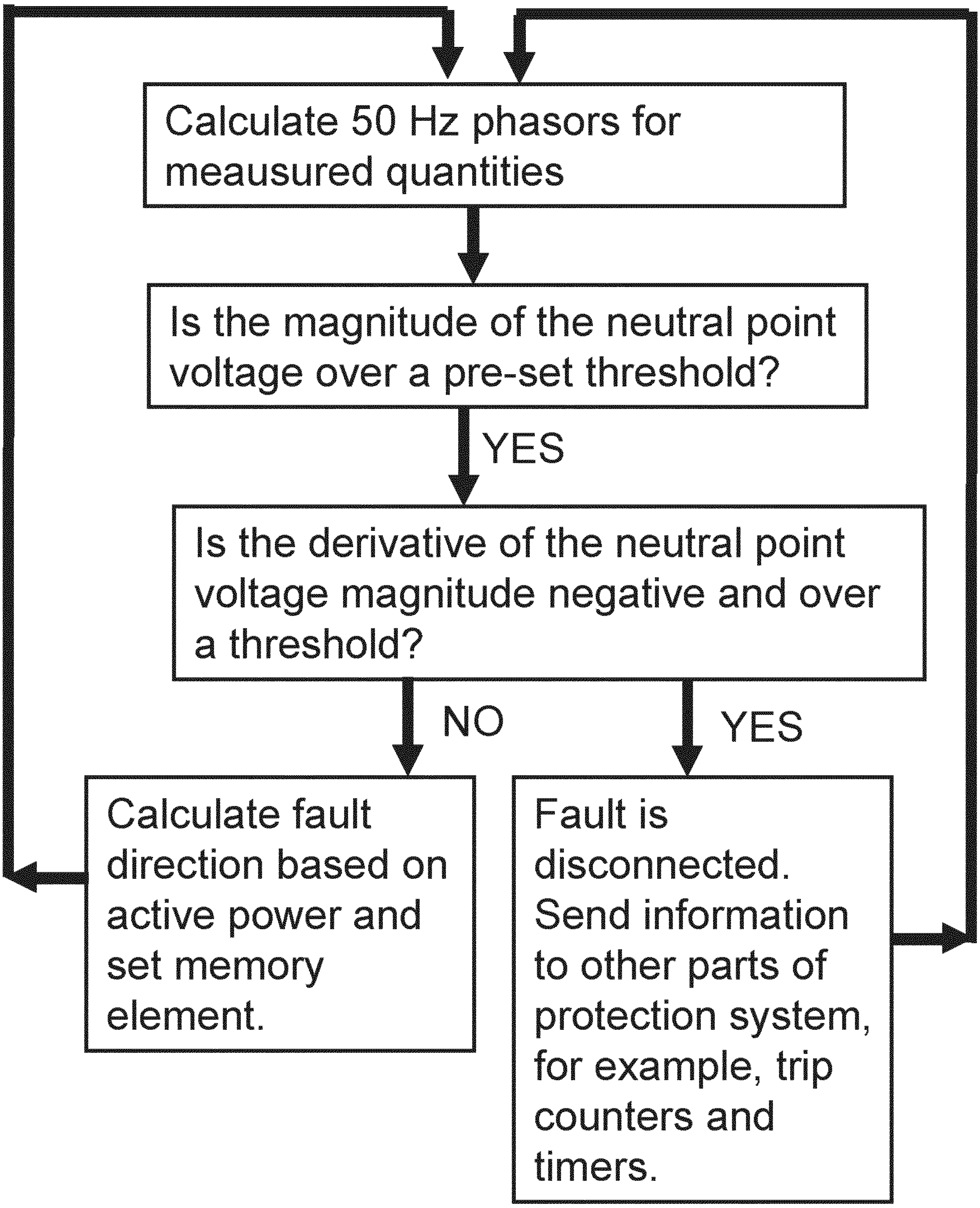
Calculate 50 Hz phasors for meausured quantities
Is the magnitude of the neutral point voltage over a pre-set threshold?
YES
Is the derivative of the neutral point voltage magnitude negative and over a threshold?
NO
YES
Calculate fault direction based on active power and set memory element.
Fault is disconnected. Send information to other parts of protection system, for example, trip counters and timers.

Fig 11

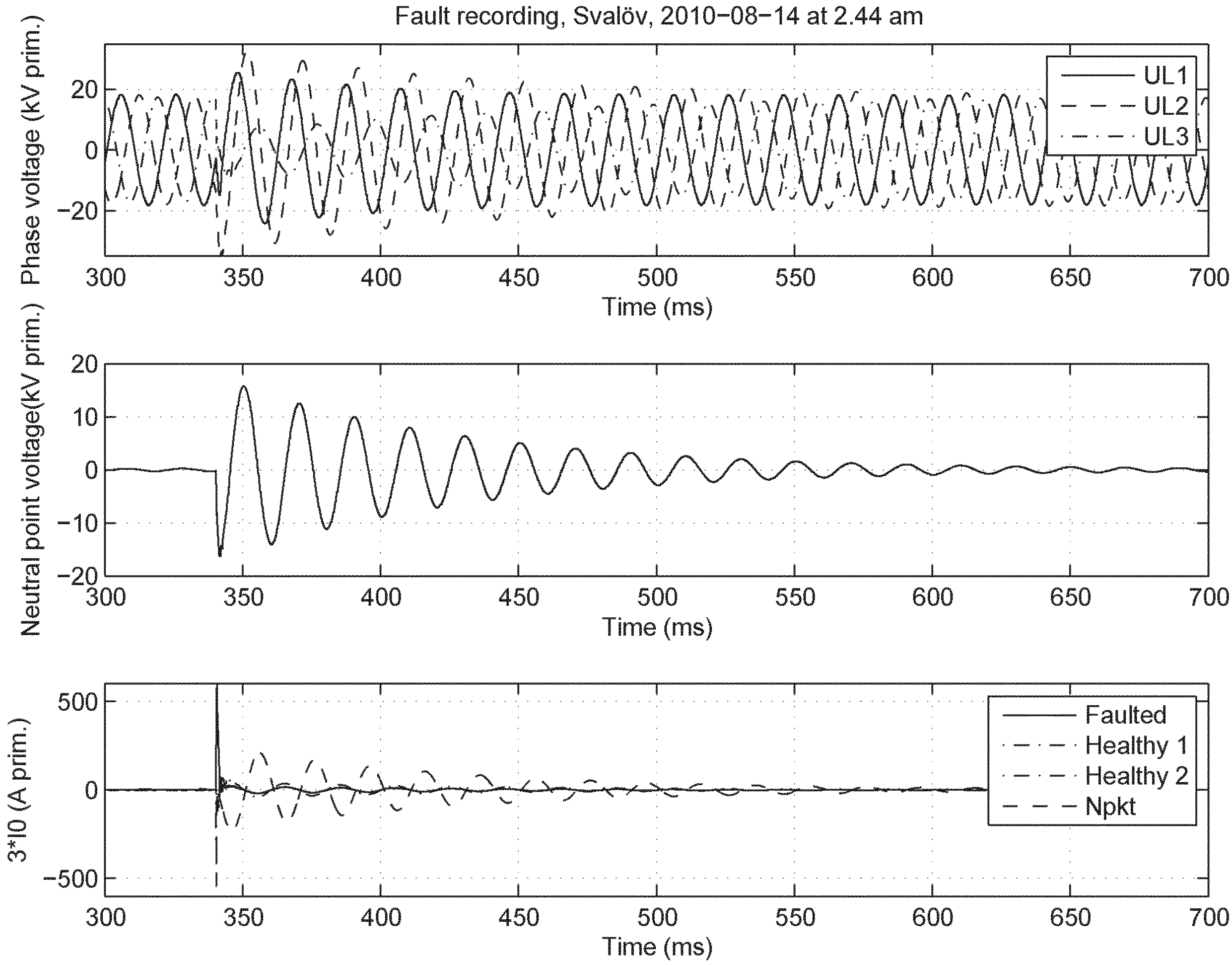
Fault recording, Svalöv, 2010−08−14 at 2.44 am
Phase voltage (kV prim.)
20
0
−20
300
350
400
450
500
550
600
650
700
Time (ms)
UL1
UL2
UL3
Neutral point voltage(kV prim.)
20
10
0
−10
−20
Time (ms)
3*I0 (A prim.)
500
0
−500
Time (ms)
Faulted
Healthy 1
Healthy 2
Npkt

Fig 12A

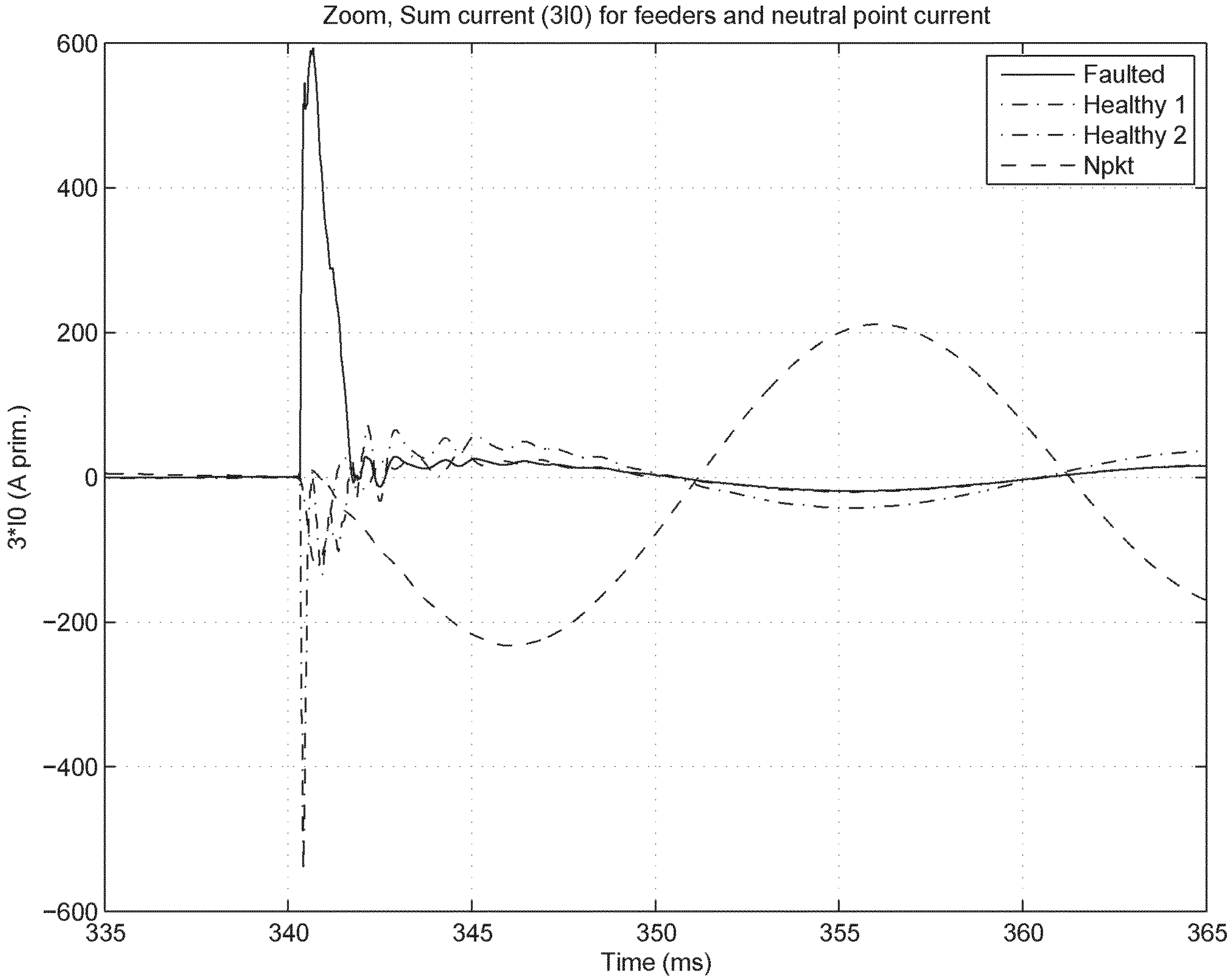
Zoom, Sum current (3I0) for feeders and neutral point current
600
400
200
0
−200
−400
−600
3*I0 (A prim.)
335
340
345
350
355
360
365
Time (ms)
Faulted
Healthy 1
Healthy 2
Npkt

Fig 12B

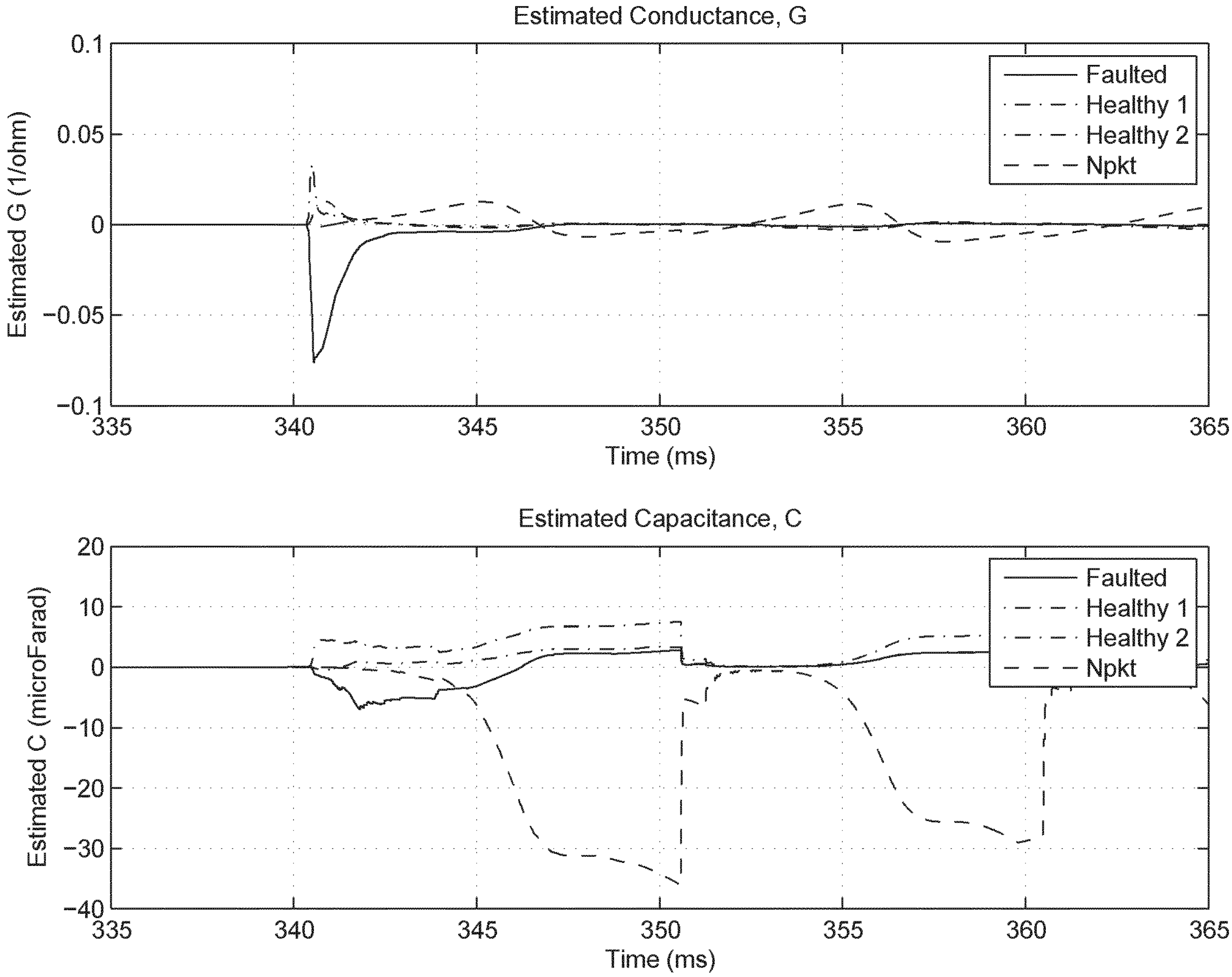
Estimated Conductance, G
Estimated G (1/ohm)
0.1
0.05
0
−0.05
−0.1
335
340
345
350
355
360
365
Time (ms)
Faulted
Healthy 1
Healthy 2
Npkt
Estimated Capacitance, C
Estimated C (microFarad)
20
10
0
−10
−20
−30
−40
335
340
345
350
355
360
365
Time (ms)
Faulted
Healthy 1
Healthy 2
Npkt

Fig 12C

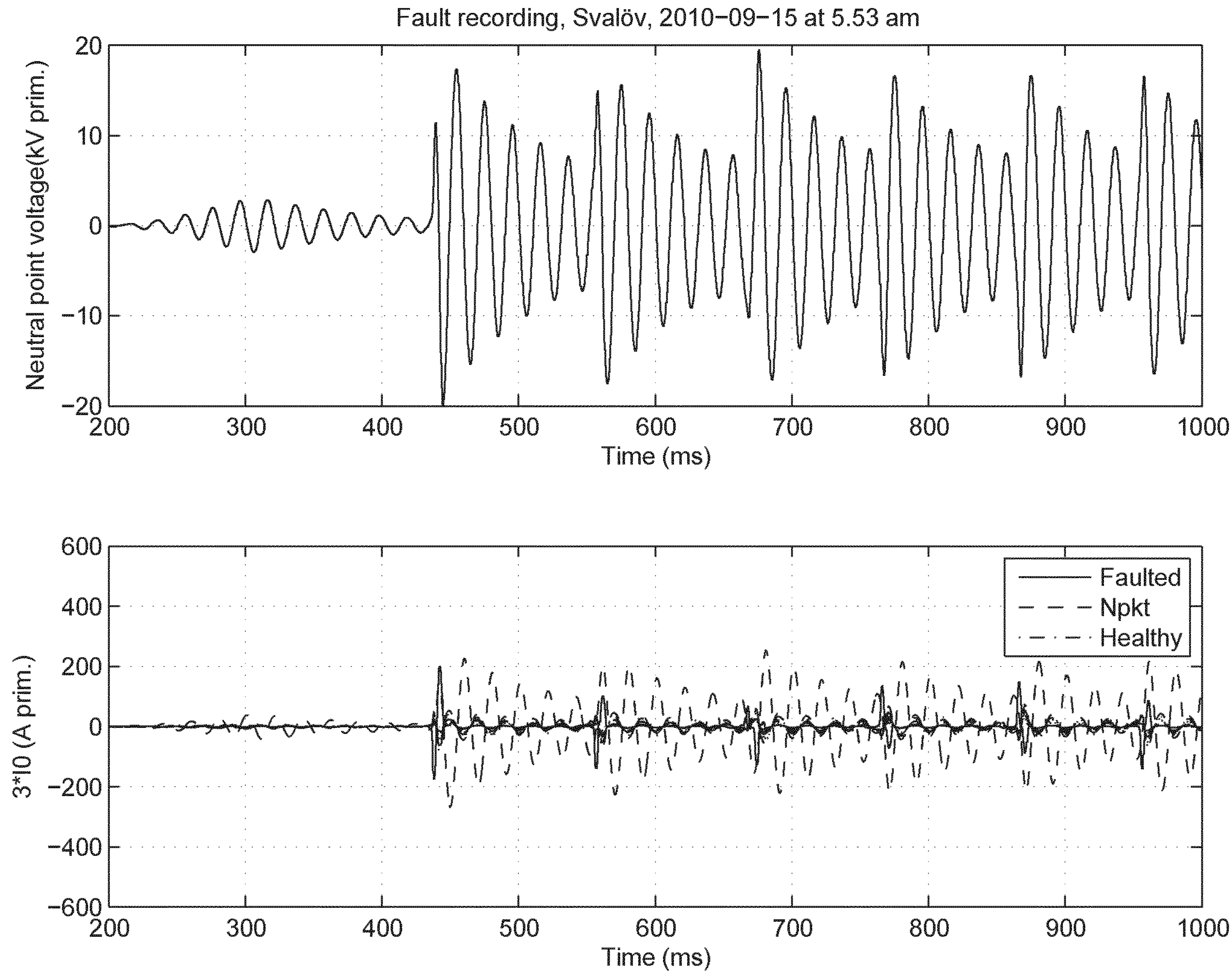
Fault recording, Svalöv, 2010−09−15 at 5.53 am
Neutral point voltage(kV prim.)
20
10
0
−10
−20
200
300
400
500
600
700
800
900
1000
Time (ms)
3*I0 (A prim.)
600
400
200
0
−200
−400
−600
Faulted
Npkt
Healthy

Fig 13A

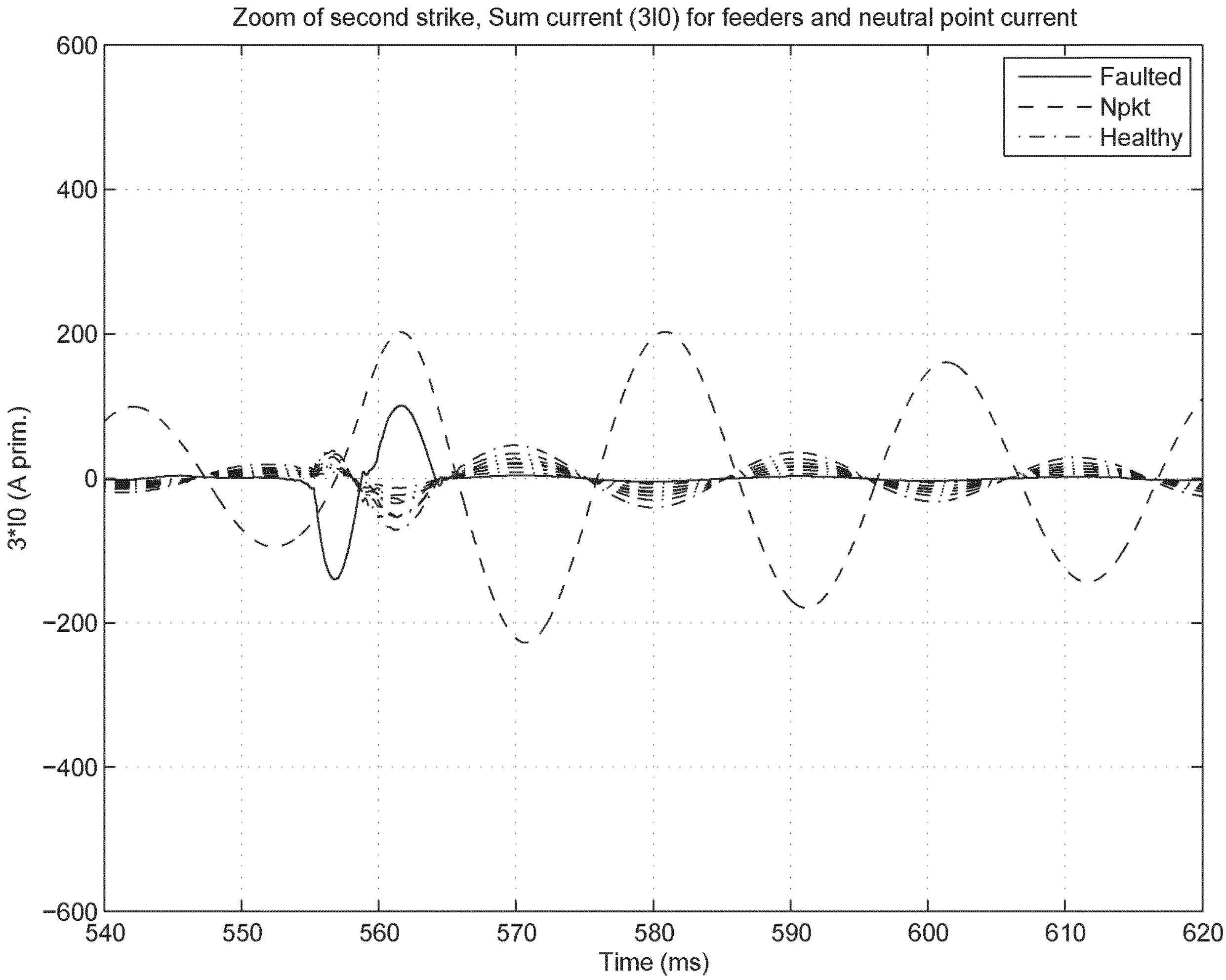
Zoom of second strike, Sum current (3I0) for feeders and neutral point current
Faulted
Npkt
Healthy
3*I0 (A prim.)
600
400
200
0
−200
−400
−600
540
550
560
570
580
590
600
610
620
Time (ms)

Fig 13B

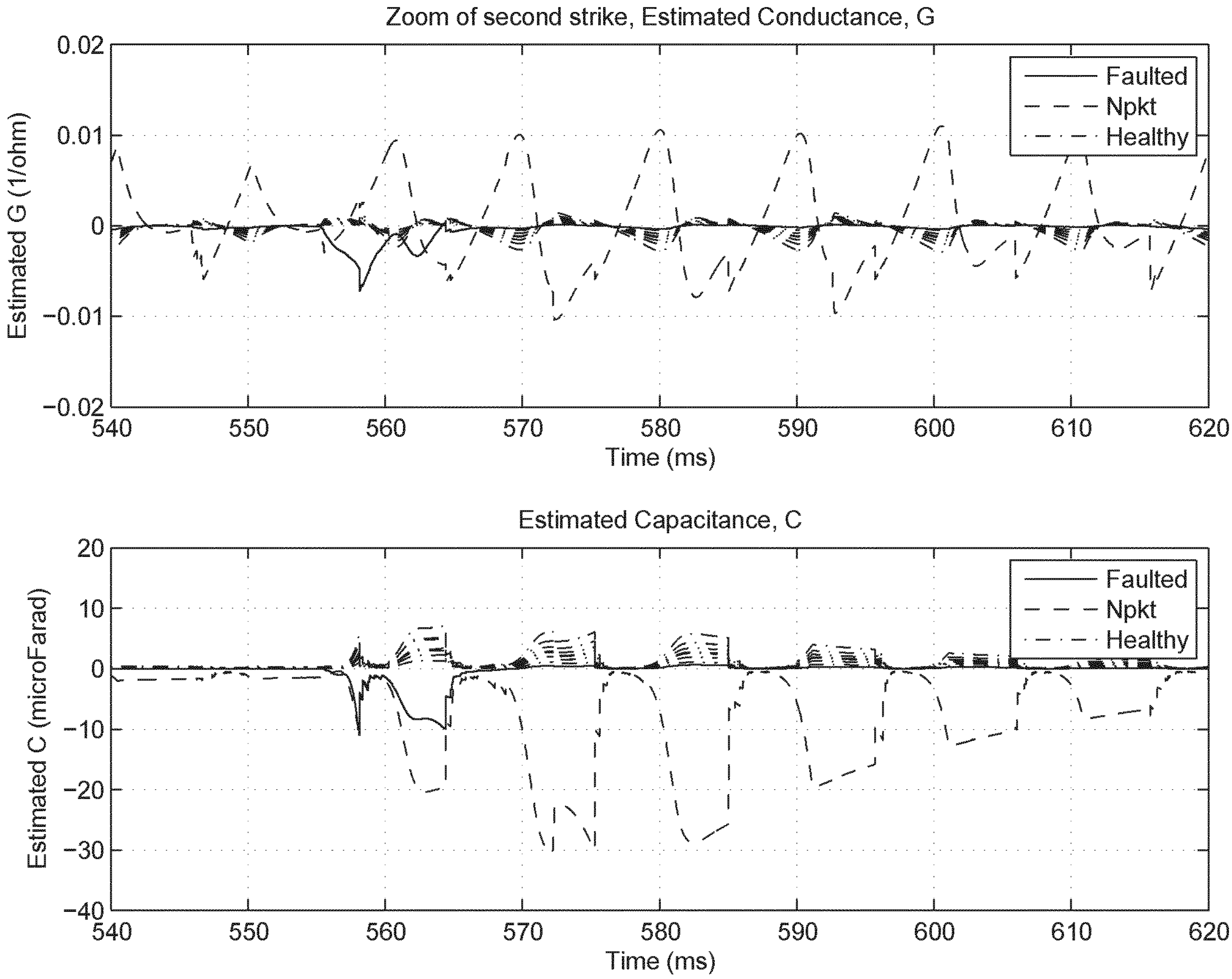
Zoom of second strike, Estimated Conductance, G
Estimated G (1/ohm)
0.02
0.01
0
−0.01
−0.02
540
550
560
570
580
590
600
610
620
Time (ms)
Faulted
Npkt
Healthy
Estimated Capacitance, C
Estimated C (microFarad)
20
10
0
−10
−20
−30
−40
540
550
560
570
580
590
600
610
620
Time (ms)
Faulted
Npkt
Healthy

Fig 13C

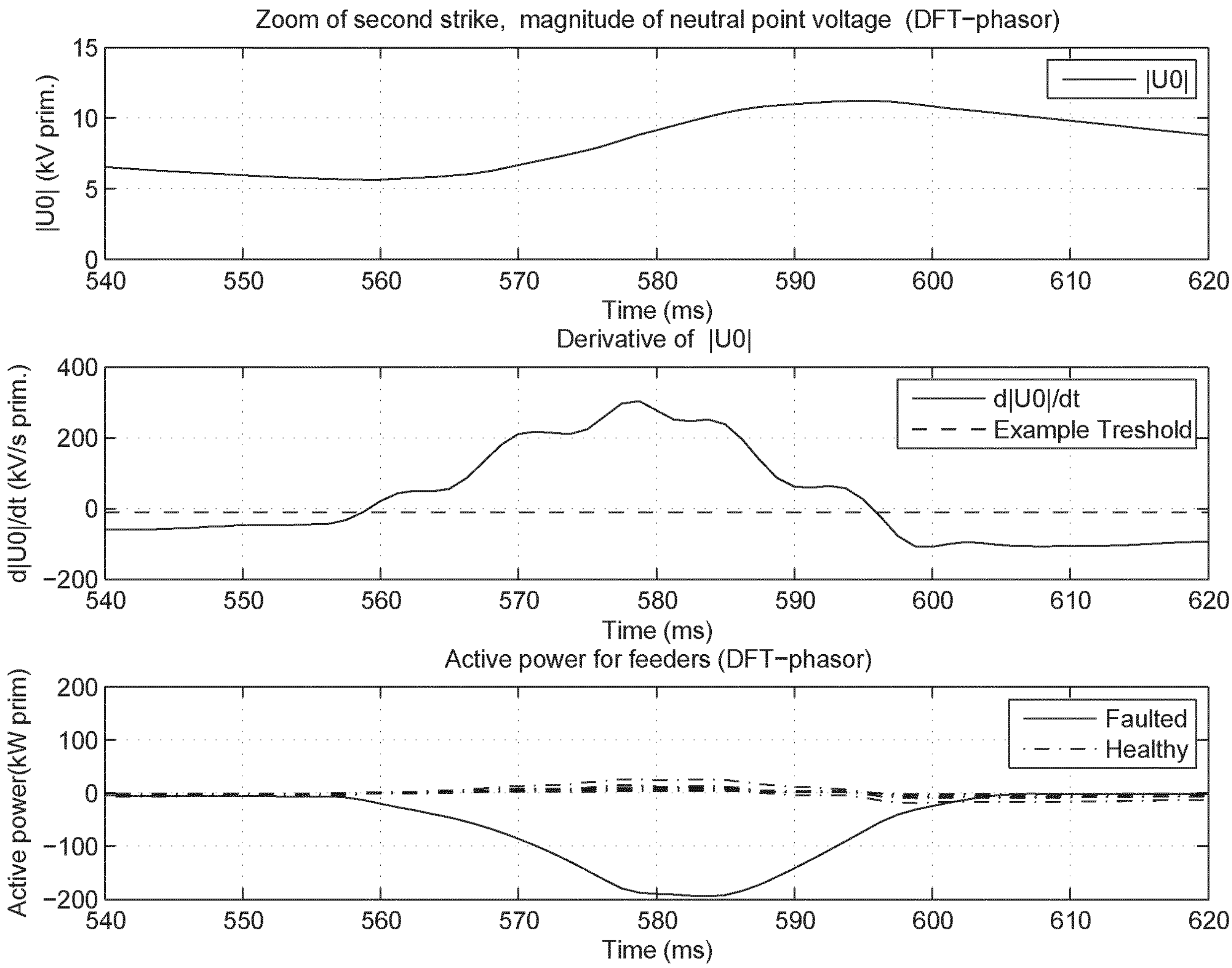

Zoom of second strike, magnitude of neutral point voltage (DFT−phasor)
|U0| (kV prim.)
|U0|
Time (ms)
Derivative of |U0|
d|U0|/dt (kV/s prim.)
d|U0|/dt
Example Treshold
Time (ms)
Active power for feeders (DFT−phasor)
Active power(kW prim)
Faulted
Healthy
Time (ms)


# Fig 13D

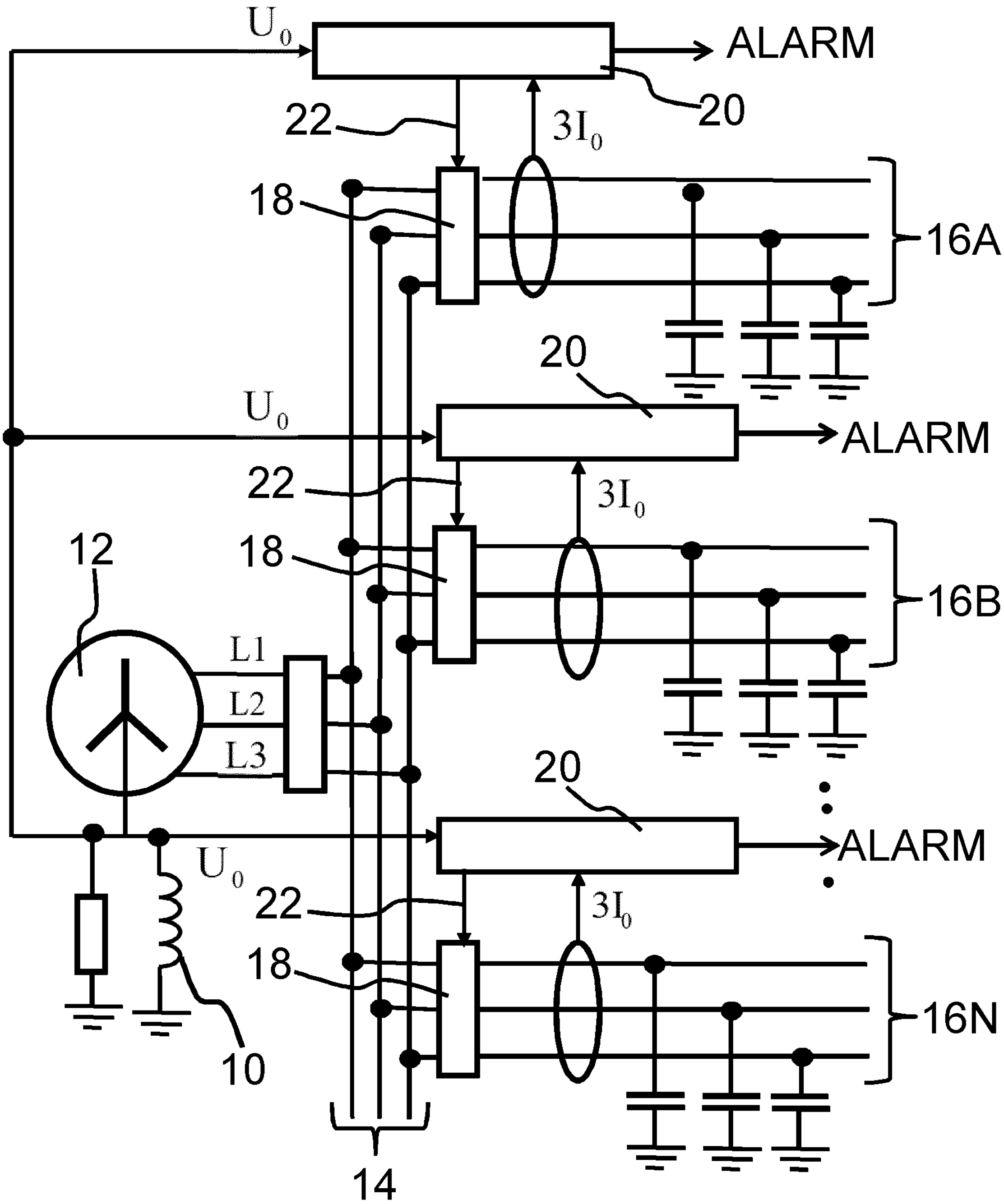
U0
ALARM
22
20
3I0
18
16A
20
U0
ALARM
22
3I0
12
18
16B
L1
L2
L3
20
ALARM
U0
22
3I0
18
16N
10
14

Figure 14.

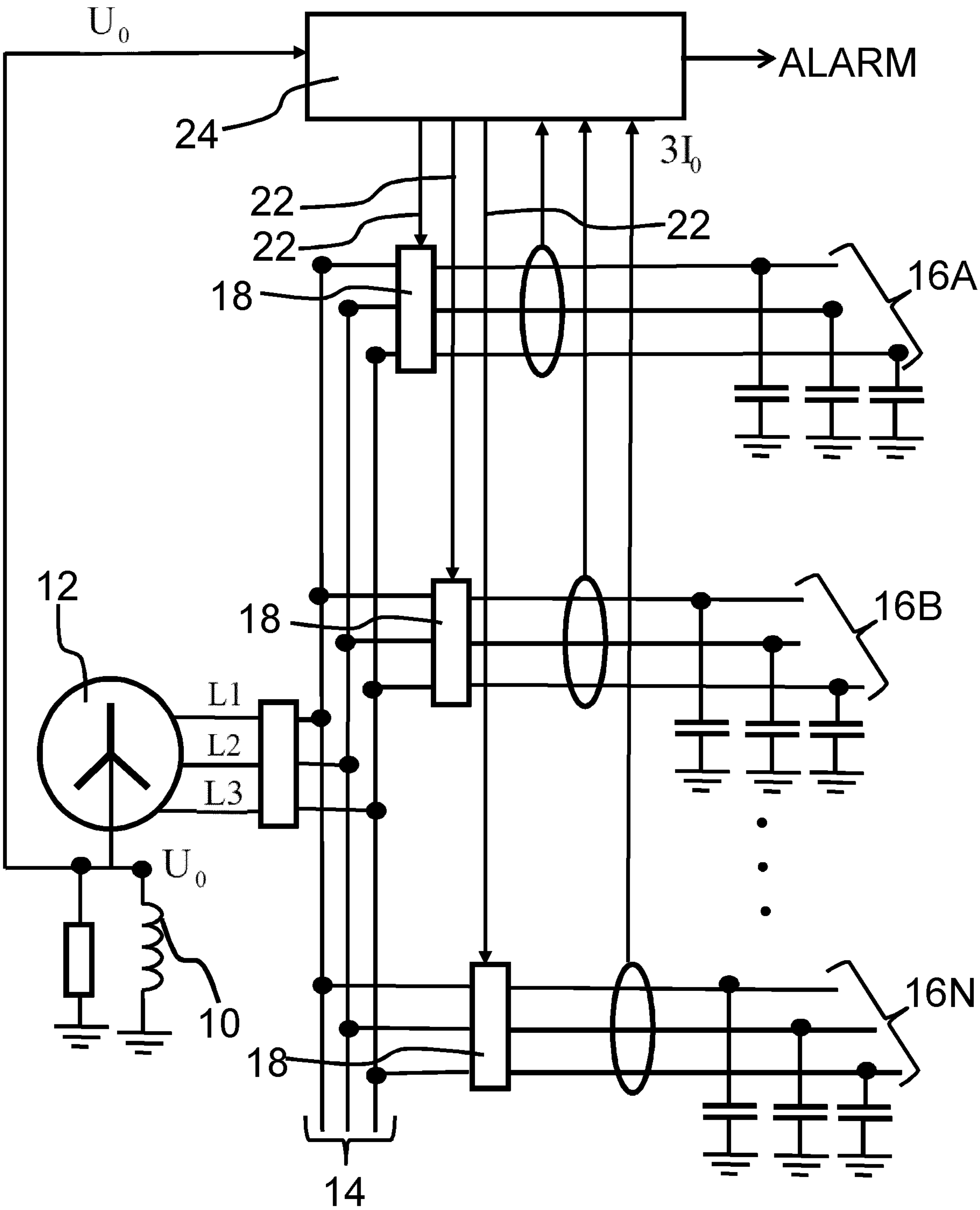


Figure 15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 0999633 A
- WO 1999012048 A
- EP 1089081 A2
- EP 1598674 A1
- WO 0184687 A2
- WO 2010115474 A